# EUROPEAN PATENT APPLICATION

(11) **EP 4 610 605 A1**
(43) Date of publication of application: **03.09.2025**
(21) Application number: 23882406.4
(22) Date of filing: 10.10.2023
(51) Int. Cl.: G01J 1/02, G01J 1/42, H10N 10/00, H10N 10/13

(54) **INFRARED SENSOR**

(30) Priority: 25.10.2022 JP 2022170777
(71) Applicant: Panasonic Intellectual Property Management Co., Ltd., Kadoma-shi, Osaka 571-0057 (JP)
(72) Inventor: NAKAMURA Kunihiko, Kadoma-shi, Osaka 571-0057 (JP)
(74) Representative: Grünecker Patent- und Rechtsanwälte PartG mbB
(86) International application number: PCT/JP2023/036728
(87) International publication number: WO 2024/090197

(57) **Abstract**

An infrared sensor (1) includes a semiconductor substrate (10), an insulating layer (20), an infrared light reflection structure (30), a light receiver (40), a midair supporter (50), and a thermoelectric converter. The insulating layer (20) is located on an upper surface (11) of the semiconductor substrate (10). The infrared light reflection structure (30) is provided in the insulating layer (20). The light receiver (40) is located above the infrared light reflection structure (30). The midair supporter (50) supports the light receiver (40) in midair so that a gap (51) is formed between the infrared light reflection structure (30) and the light receiver (40). The thermoelectric converter generates an infrared light detection signal on the basis of heat generated by the light receiver (40). The infrared light reflection structure (30) includes metal vias (31) that extend in the insulating layer (20) in a thickness direction of the insulating layer (20).

## Description

### Technical Field

The present disclosure relates to an infrared sensor.

### Background Art

A thermal infrared sensor that detects infrared light on the basis of heat generated when a light receiver receives the infrared light is known. The thermal infrared sensor is, for example, used in an infrared imaging device. For example, the infrared imaging device can be obtained by arranging thermal infrared sensors as pixels in an array. Reducing a heat capacity of an infrared light receiver per pixel improves followability to a change in infrared light power, thereby enabling high-speed imaging. In a case where the light receiver is formed by using a thin film, the heat capacity can be reduced by reducing area and thickness of the thin film.

However, reducing the area of the light receiver makes infrared light power that can be absorbed by light reception weak. Furthermore, using the light receiver having a small area makes it harder to obtain a spatial temperature difference. In an infrared sensor (e.g., a thermopile infrared sensor) that utilizes the Seebeck effect, that is, electromotive force based on a temperature difference as an infrared light detection signal, a reduction in temperature difference results in weak electromotive force, which decreases a signal/noise (S/N) ratio. Regarding this problem, in an infrared sensor of Patent Literature 1, a light receiver is supported in midair by a midair supporter having a phononic crystal structure that is good in heat insulation. This can keep a spatial temperature difference, thereby preventing or reducing a decrease in S/N. Specifically, in a thermopile structure including a substrate, a light receiver separated away from the substrate, and a midair supporter that supports the light receiver in such a manner that the light receiver is separated above the substrate, a phononic crystal structure is provided in the midair supporter, a cold junction is provided on a substrate side, and a hot junction is provided on a light receiver side. As a result, a hot junction temperature on the light receiver whose temperature has changed due to infrared radiation does not promptly become uniform with a cool junction temperature, and a temperature difference between the hot junction and the cool junction is maintained. This effectively obtains electromotive force due to the Seebeck effect.

### Citation List

### Patent Literature

PTL 1: International Publication No. 2019/225058
PTL 2: Japanese Unexamined Patent Application Publication No. 6-318573 Non Patent Literature

NPL 1: S. Basu, B. J. Lee and M. Zhang, "Infrared Radiative Properties of Heavily Doped Silicon at Room Temperature", Journal of Heat Transfer, Vol. 132, FEBRUARY 2010.

### Summary of Invention

The present disclosure provides an infrared sensor that can increase infrared light detection accuracy.

An infrared sensor according to an aspect of the present disclosure includes a substrate; an insulating layer located on an upper surface of the substrate; a first infrared light reflection structure provided in the insulating layer; a light receiver located above the first infrared light reflection structure; a midair supporter that supports the light receiver in midair so that a gap is formed between the first infrared light reflection structure and the light receiver; and a thermoelectric converter that generates an infrared light detection signal on the basis of heat generated in the light receiver, in which the first infrared light reflection structure includes first metal vias extending in the insulating layer in a thickness direction of the insulating layer.

According to the present disclosure, it is possible to increase infrared light detection accuracy.

### Brief Description of Drawings

[Fig. 1] Fig. 1 is a cross-sectional view illustrating an infrared sensor according to a comparative example.
[Fig. 2A] Fig. 2A is a cross-sectional view illustrating an infrared sensor according to Embodiment 1.
[Fig. 2B] Fig. 2B is a plan view of the infrared sensor according to Embodiment 1 viewed from above.
[Fig. 2C] Fig. 2C is a plan view obtained in a case where a light receiver and a midair supporter of the infrared sensor illustrated in Fig. 2B are seen through.
[Fig. 3A] Fig. 3A is a cross-sectional view for explaining a method for producing the infrared sensor according to Embodiment 1.
[Fig. 3B] Fig. 3B is a cross-sectional view for explaining the method for producing the infrared sensor according to Embodiment 1.
[Fig. 3C] Fig. 3C is a cross-sectional view for explaining the method for producing the infrared sensor according to Embodiment 1.
[Fig. 3D] Fig. 3D is a cross-sectional view for explaining the method for producing the infrared sensor according to Embodiment 1.
[Fig. 3E] Fig. 3E is a cross-sectional view for explaining the method for producing the infrared sensor according to Embodiment 1.
[Fig. 4A] Fig. 4A is a top view of an infrared light reflection structure according to Embodiment 1 used for calculation of thermal behavior.
[Fig. 4B] Fig. 4B is a cross-sectional view of the infrared light reflection structure according to Embodiment 1 used for calculation of thermal behavior.
[Fig. 5A] Fig. 5A is a top view of an infrared light reflection structure according to a comparative example used for calculation of thermal behavior.
[Fig. 5B] Fig. 5B is a cross-sectional view of the infrared light reflection structure according to the comparative example used for calculation of thermal behavior.
[Fig. 6] Fig. 6 illustrates a calculation result of temperature changes in the infrared light reflection structures according to Embodiment 1 and the comparative example.
[Fig. 7A] Fig. 7A is a cross-sectional view for explaining a step of mounting the infrared sensor according to Embodiment 1 on a package.
[Fig. 7B] Fig. 7B is a cross-sectional view for explaining a step of mounting the infrared sensor according to Embodiment 1 on the package.
[Fig. 7C] Fig. 7C is a cross-sectional view for explaining a step of mounting the infrared sensor according to Embodiment 1 on the package.
[Fig. 7D] Fig. 7D is a cross-sectional view for explaining a step of mounting the infrared sensor according to Embodiment 1 on the package.
[Fig. 8] Fig. 8 is a cross-sectional view illustrating setup for obtaining a correction coefficient for correcting an infrared light detection signal.
[Fig. 9] Fig. 9 illustrates an example of a relationship between a set temperature of a blackbody furnace and an infrared light detection signal.
[Fig. 10] Fig. 10 is a plan view of an infrared light reflection structure according to Modification 1 of Embodiment 1 viewed from above.
[Fig. 11] Fig. 11 is a plan view of an infrared light reflection structure according to Modification 2 of Embodiment 1 viewed from above.
[Fig. 12] Fig. 12 is a cross-sectional view illustrating an infrared sensor according to Embodiment 2.
[Fig. 13A] Fig. 13A is a cross-sectional view illustrating an infrared sensor according to Embodiment 3.
[Fig. 13B] Fig. 13B is a cross-sectional view illustrating a part of an infrared light reflection structure included in the infrared sensor according to Embodiment 3.
[Fig. 13C] Fig. 13C is a plan view of the infrared sensor according to Embodiment 3 viewed from above.
[Fig. 14A] Fig. 14A is a cross-sectional view illustrating an infrared sensor according to Embodiment 4.
[Fig. 14B] Fig. 14B is a plan view of the infrared sensor according to Embodiment 4 viewed from above.

### Description of Embodiments

### (Underlying Knowledge Forming Basis of the Present Disclosure)

There are demands for an infrared sensor having improved infrared light detection accuracy. In a case where a thin-film light receiver is used as described above, a rate at which radiated infrared light passes through the thin light receiver increases, and S/N decreases. As a result, for example, just by insulating heat by supporting the light receiver in midair, it is hard to stably obtain electromotive force due to the Seebeck effect.

One means for improving a decrease in S/N caused by a reduction in film thickness of the light receiver is to provide a metal reflection film on a side opposite to a light source when viewed from the light receiver so that infrared light that has passed through the light receiver is reflected again and is absorbed by the light receiver again, and thereby prevent or reduce a decrease in infrared light absorption amount of the light receiver. In this case, the metal reflection film is, for example, provided directly below the light receiver so as to be located on a substrate with an insulating film interposed therebetween. As a material for the metal reflection film, a high-melting-point metal such as tungsten (W) is suitable, for example. Since a thermopile includes, for example, a P-type semiconductor and an N-type semiconductor, the metal reflection film is exposed to a high temperature in an impurity doping and annealing step. The metal reflection film that is made of a high-melting-point metal can withstand this temperature.

The inventor of the present invention found that there are problems such as a problem that an error of an infrared light detection signal of an infrared sensor cannot be sufficiently reduced even by using such a metal reflection film. The following describes the problems in an infrared sensor using a metal reflection film while referring to an infrared sensor according to a comparative example.

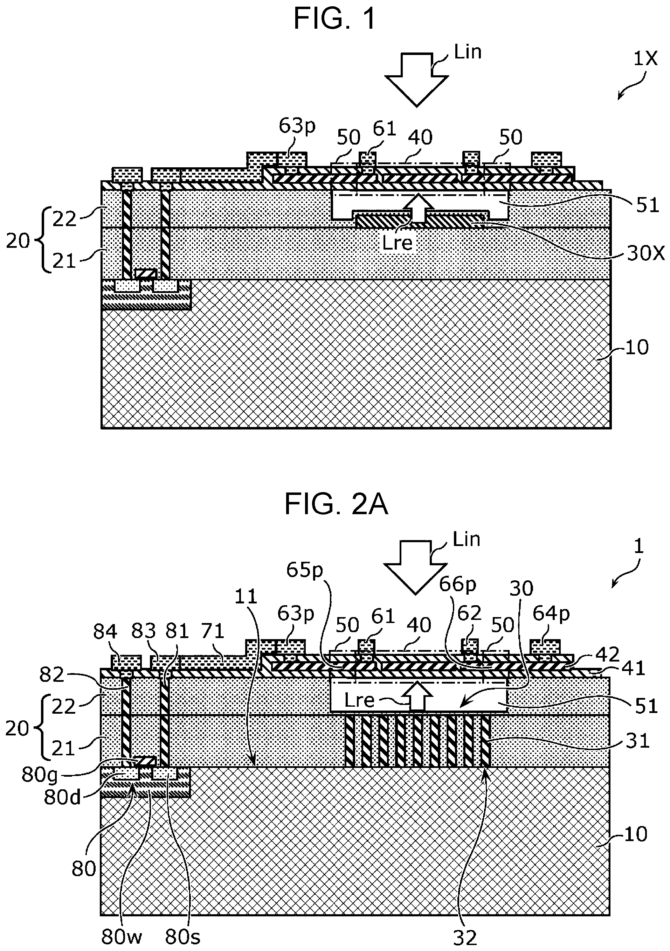

Fig. 1 is a cross-sectional view illustrating an infrared sensor 1X according to a comparative example.

As illustrated in Fig. 1, the infrared sensor 1X according to the comparative example includes a semiconductor substrate 10, an insulating layer 20, a metal reflection film 30X, a light receiver 40, and a midair supporter 50. Furthermore, the infrared sensor 1X includes a hot junction metal electrode 61 and a cold junction metal electrode 63p. In the infrared sensor 1X, electromotive force according to a temperature difference between the hot junction metal electrode 61 and the cold junction metal electrode 63p is generated.

The insulating layer 20 includes an insulating film 21 located on the semiconductor substrate 10 and an insulating film 22 located on the insulating film 21. The metal reflection film 30X is located on the insulating film 21. The metal reflection film 30X is, for example, made of a high-melting-point metal such as tungsten. The light receiver 40 is supported by the midair supporter 50 and is thus disposed above the metal reflection film 30X with a gap interposed therebetween.

In formation of the infrared sensor 1X, dry etching of tungsten of which the metal reflection film 30X is made and an adhesion layer thereof is two-step etching that requires replacement of etching gas, as described in Patent Literature 2. This undesirably leads to poor productivity.

Furthermore, the metal reflection film 30X undesirably becomes a cause of an error of detection of the infrared sensor 1X.

Specifically, the electric insulating film 21 used in a typical electronic device is low in thermal conductivity in general. When heat is generated in the metal reflection film 30X provided on the insulating film 21 provided on the semiconductor substrate 10, it is hard for the heat to escape to the semiconductor substrate 10 through the insulating film 21. The heat generated in the metal reflection film 30X is mainly heat generated when a part of infrared light that has not been reflected by the metal reflection film 30X is absorbed by the metal reflection film 30X.

Since the metal reflection film 30X is provided on the insulating film 21 having low thermal conductivity, it takes time for the temperature of the metal reflection film 30X to fit into the temperature of the semiconductor substrate 10 that can be regarded as a hot bath. That is, as an environmental temperature around the infrared sensor 1X changes, the temperature of the semiconductor substrate 10 also changes, but a temperature change of the metal reflection film 30X is delayed relative to the temperature change of the semiconductor substrate 10. Furthermore, although the temperature of the metal reflection film 30X changes by absorbing a part of infrared incident light whose incident amount changes from moment to moment, it is difficult to grasp the temperature of the metal reflection film 30X itself. Since the metal reflection film 30X whose temperature is unknown is close to the light receiver 40 and the metal reflection film 30X and the light receiver 40 have a relationship of radiation with each other, the temperature of the hot junction metal electrode 61 on the light receiver 40 is influenced by the temperature of the metal reflection film 30X whose temperature is unknown. The influence also reaches a temperature difference between the hot junction metal electrode 61 and the cold junction metal electrode 63p and electromotive force generated from the temperature difference.

A temperature rise of the metal reflection film 30X is not mitigated until a period several times (e.g., 5 times) longer than a thermal time constant τ elapses where τ is a thermal time constant it takes for the heat generated in the metal reflection film 30X to escape to the semiconductor substrate 10 and air (in a case where a gap 51 is not vacuum but air) and for the temperature to be mitigated. Accordingly, the influence of the temperature of the metal reflection film 30X within past 5τ is included in the temperatures of the light receiver 40 and the hot junction metal electrode 61.

In a case where the infrared sensor 1X detects infrared light at a sampling rate of less than 5τ, (N-1)th infrared light detection information is mixed as an error cause in N-th infrared light detection information. That is, this error cause is included in an S component contrary to the purpose of improving S/N by providing the metal reflection film 30X. To eliminate this error cause, it is only necessary to set the sampling rate to 5τ or more, but this 5τ becomes a limit on a speed of detection or imaging. Therefore, this error cause is a problem that is contrary to the above advantage that using the thin light receiver 40 having a reduced heat capacity improves followability to a change in infrared light power.

Although the above description is description concerning behavior of heat generated in the metal reflection film 30X due to infrared light applied to the infrared sensor 1X, a factor influencing the temperature of the metal reflection film 30X that is an error cause is not limited to this infrared light. For example, in a case where an environmental temperature around the infrared sensor 1 rapidly fluctuates, the temperature of the semiconductor substrate 10 that is widely in contact with the environment also fluctuates, but a temperature change of the metal reflection film 30X provided on the insulating film 21 is gradual as compared with this. Although the temperature of the semiconductor substrate 10 can be, for example, grasped by a temperature sensor, the temperature of the metal reflection film 30X is unknown. Accordingly, influence given by the metal reflection film 30X whose temperature is unknown on the temperature of the light receiver 40 through radiation is an error cause that is hard to correct.

As a result of diligent studies, the inventor of the present invention focused on metal vias connected to a transistor provided on a substrate and found that the above problems can be solved by using similar metal vias in an infrared light reflection structure. Based on this finding, the inventor of the present invention attained an aspect of the present disclosure. This is described in detail below.

### (Outline of Present Disclosure)

An example of an infrared sensor according to the present disclosure is illustrated below.

An infrared sensor according to a first aspect of the present disclosure includes a substrate; an insulating layer located on an upper surface of the substrate; a first infrared light reflection structure provided in the insulating layer; a light receiver located above the first infrared light reflection structure; a midair supporter that supports the light receiver in midair so that a gap is formed between the first infrared light reflection structure and the light receiver; and a thermoelectric converter that generates an infrared light detection signal on the basis of heat generated in the light receiver, in which the first infrared light reflection structure includes first metal vias extending in the insulating layer in a thickness direction of the insulating layer.

With this configuration, infrared light that has passed through the light receiver and passed the gap is reflected by the first infrared light reflection structure and is absorbed by the light receiver. This can increase an infrared light absorption amount of the light receiver. As a result, the infrared light detection signal generated by the thermoelectric converter on the basis of heat of the light receiver increases, and S/N can be improved.

Furthermore, the temperature of the first infrared light reflection structure can rise by absorbing the infrared light, and therefore influences the temperature of the light receiver through radiation or the like in a case where the temperature rises. It is desirable to always grasp the temperature of the first infrared light reflection structure, and one way to achieve this is a state where the temperature of the first infrared light reflection structure easily fits into the hot bath promptly. **In** the infrared sensor according to this aspect, the first infrared light reflection structure includes the first metal vias extending in the insulating layer on the substrate in the thickness direction of the insulating layer, and the first metal vias can be brought into contact with the substrate or can be brought closer to the substrate than in a case where a metal reflection film is provided on the insulating layer. As a result, the temperature of the first metal vias can be promptly brought into a temperature equal to the temperature of the substrate that can be regarded as a hot bath whose heat capacity is large and whose temperature is hard to change. This brings two advantages: (i) (N - 1)th infrared light detection information is less likely to be mixed in N-th infrared light detection information and (ii) a temperature change of the first infrared light reflection structure caused by absorption of infrared light at a time of N-th sampling is small, and the temperature of the first infrared light reflection structure can be regarded as being equal to the substrate temperature. Accordingly, the temperature of the first infrared light reflection structure is hard to change and gives less influence to the temperature of the light receiver, and it is therefore possible to reduce an error of the infrared light detection signal generated by the thermoelectric converter. Furthermore, the temperature of the first metal vias, that is, the first infrared light reflection structure is known by grasping the temperature of the substrate by a temperature meter such as a thermistor. Since influence given by the temperature of the first infrared light reflection structure on the temperature of the light receiver can be grasped in advance by grasping the temperature of the substrate, the infrared light detection signal can be corrected. It is therefore possible to eliminate a component that depends on the temperature of the first infrared light reflection structure in the infrared light detection signal and thereby increase detection accuracy.

According to the infrared sensor according to the present aspect, it is thus possible to increase infrared light detection accuracy.

The first metal vias can be formed by a wiring step used in conventional semiconductor device production of filling via holes formed in an insulating layer with a metal and the performing a polishing process by chemical mechanical polishing (CMP). Since the infrared sensor can be produced without using dry etching of poor productivity that is used to form a metal reflection film, productivity can be improved.

For example, an infrared sensor according to a second aspect of the present disclosure is the infrared sensor according to the first aspect further including a second infrared light reflection structure disposed so as to surround the light receiver and the gap in plan view, in which the second infrared light reflection structure includes second metal vias extending in the insulating layer in the thickness direction of the insulating layer.

With this configuration, reflected light that is reflected by the first infrared light reflection structure but does not travel toward the light receiver can be reflected by the second infrared light reflection structure and absorbed by the light receiver. It is therefore possible to further increase the infrared light absorption amount of the light receiver.

For example, an infrared sensor according to a third aspect of the present disclosure is the infrared sensor according to the second aspect in which the thermoelectric converter is a thermopile thermoelectric conversion element including a hot junction metal electrode and a cold junction metal electrode, and one of the second metal vias is in contact with the cold junction metal electrode.

With this configuration, heat of the cold junction metal electrode easily moves to the substrate due to the second metal via provided in the insulating layer on the substrate, and it is therefore possible to stabilize the temperature of the cold junction metal electrode. As a result, a temperature difference between the hot junction metal electrode and the cold junction metal electrode is stabilized, and accuracy of the infrared light detection signal generated by the thermoelectric converter can be increased.

For example, an infrared sensor according to a fourth aspect of the present disclosure is the infrared sensor according to the third aspect further including a transistor that switches whether or not the infrared light detection signal generated by the thermoelectric converter is output from the cold junction metal electrode, in which the transistor is provided on the substrate, and an input terminal of the transistor is electrically connected to the cold junction metal electrode by the one of the second metal vias.

With this configuration, the transistor can be positioned below the cold junction metal electrode. This can reduce an area of the infrared sensor in plan view, thereby achieving a reduction in size of the infrared sensor.

For example, an infrared sensor according to a fifth aspect of the present disclosure is the infrared sensor according to any one of the first to fourth aspects in which parts of outer peripheries of the first metal vias in plan view are connected to each other.

With this configuration, it is easy to increase a density of the first metal vias in plan view. It is therefore possible to increase infrared light reflectivity of the first infrared light reflection structure.

For example, an infrared sensor according to a sixth aspect of the present disclosure is the infrared sensor according to any one of the first to fifth aspects in which end surfaces of the first metal vias on a substrate side are in contact with the substrate.

With this configuration, the first metal vias are directly joined to the substrate that can be regarded as a hot bath, and therefore even if external disturbance of a temperature is applied to the first metal vias, the temperature of the first metal vias can be brought close to the temperature of the substrate more promptly.

For example, an infrared sensor according to a seventh aspect of the present disclosure is the infrared sensor according to any one of the first to fifth aspects further including a gate electrode located on the upper surface of the substrate, in which end surfaces of the first metal vias on a substrate side are in contact with the gate electrode.

With this configuration, the first metal vias are joined to the substrate that can be regarded as a hot bath with the gate electrode interposed therebetween, and the gate electrode includes a gate oxide film having a nanometer-level small thickness that hardly hinders thermal conduction, and therefore even if external disturbance of a temperature is applied to the first metal vias, the temperature of the first metal vias can be brought close to the temperature of the substrate more promptly.

For example, an infrared sensor according to an eighth aspect of the present disclosure is the infrared sensor according to any one of the first to seventh aspects in which the substrate has a high-concentration impurity region doped with an impurity, the high-concentration impurity region is located in an upper end portion of the substrate and located below the first infrared light reflection structure, and an impurity concentration of the high-concentration impurity region is higher than an impurity concentration of a portion of the substrate that is located below the high-concentration impurity region.

Since reflectivity of infrared light is high in such a high-concentration impurity region of the substrate that is doped with an impurity at a high concentration, reflectivity increases due to a synergistic effect produced by the reflection effect of the first metal vias and the reflection effect of the high-concentration impurity region. It is therefore possible to further increase the infrared light absorption amount of the light receiver.

For example, an infrared sensor according to a ninth aspect of the present disclosure is the infrared sensor according to any one of the first to eighth aspects in which the midair supporter has a phononic crystal structure.

Due to a heating insulating property of the phononic crystal structure of the midair supporter, it is hard for heat of the light receiver whose temperature has changed upon irradiation of infrared light to escape, and therefore infrared light detection sensitivity of the thermoelectric converter improves.

Embodiments of the present disclosure are described below with reference to the drawings.

Each of the embodiments described below illustrates a general or specific example. Numerical values, shapes, materials, constituent elements, the way in which the constituent elements are disposed and connected, steps, the order of steps, and the like illustrated in the embodiments below are examples and do not limit the present disclosure. Among constituent elements in the embodiments below, constituent elements that are not described in independent claims are described as optional constituent elements.

Each drawing is a schematic view and is not necessarily strict illustration. Accordingly, for example, scales and the like in the drawings do not necessarily match. **In** the drawings, substantially identical constituent elements are given identical reference signs, and repeated description thereof is omitted or simplified.

In the present specification, terms indicating relationships between elements such as "parallel", terms indicating shapes of elements such as "rectangular", and numerical value ranges are not expressions expressing only strict meaning, but expressions encompassing substantially equivalent ranges, for example, differences of approximately several %.

In the present specification, terms "upper/upward/above" and "lower/downward/below" do not indicate an upward direction (vertically upward) and a downward direction (vertically downward) in absolute space recognition but are used as terms defined by a relative positional relationship. Specifically, a light receiving side of an infrared sensor is referred to as "upper/upward/above", and a side opposite to the light receiving side is referred to as "lower/downward/below". Note that terms such as 'upper/upward/above" and "lower/downward/below" are merely used to designate relative positions of members and do not intend to limit a posture of an infrared sensor during use. Furthermore, the terms 'upper/upward/above" and "lower/downward/below" are applied not only to a case where two constituent elements are disposed apart from each other with another constituent element interposed therebetween, but also to a case where two constituent elements are disposed in close contact with each other.

In the present specification, "plan view" means viewing from a direction perpendicular to an upper surface of a semiconductor substrate (i.e., a thickness direction of the semiconductor substrate) unless otherwise specified.

In the present specification, ordinal numbers such as "first" and "second" do not mean the number constituent elements or an order of constituent elements, and are used to distinguish constituent elements of the same kind and avoid confusion, unless otherwise specified.

### (Embodiment 1)

An infrared sensor according to Embodiment 1 is described below.

### [Configuration]

First, a configuration of the infrared sensor according to Embodiment 1 is described.

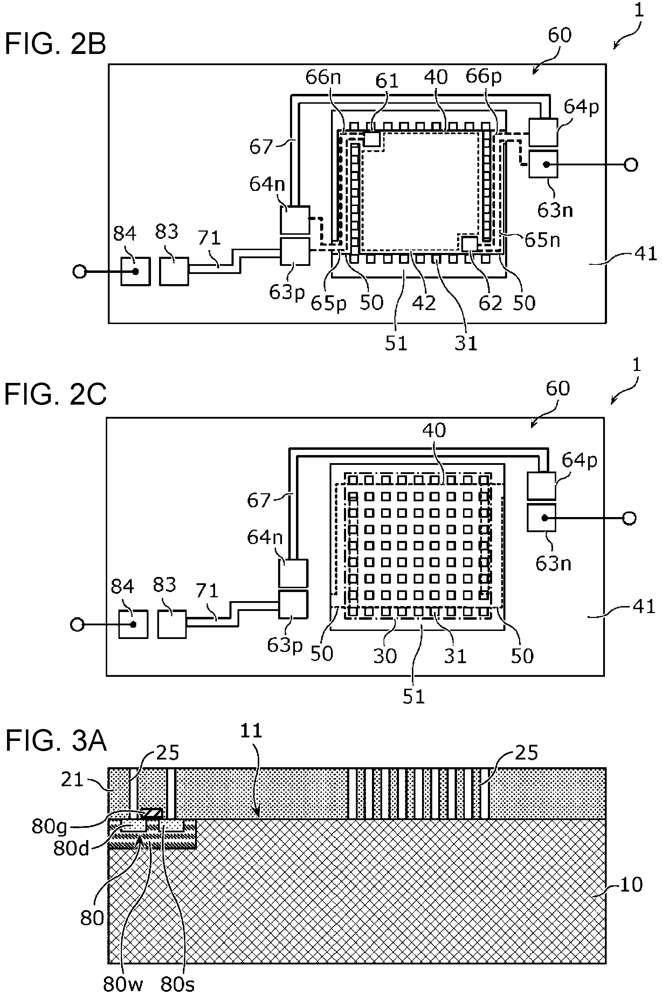

Fig. 2A is a cross-sectional view illustrating an infrared sensor 1 according to Embodiment 1. Fig. 2B is a plan view of the infrared sensor 1 according to Embodiment 1 viewed from above. Fig. 2C is a plan view obtained in a case where a light receiver 40 and a midair supporter 50 of the infrared sensor 1 illustrated in Fig. 2B are seen through. Note that Fig. 2A illustrates a cross section taken along a line passing a metal wire 84, a metal wire 83, a metal wire 71, a cold junction metal electrode 63p, a P-type semiconductor 65p, a hot junction metal electrode 61, a hot junction metal electrode 62, a P-type semiconductor 66p, and a cold junction metal electrode 64p in this order in the infrared sensor 1 illustrated in Fig. 2B. In Fig. 2B, positions of N-type semiconductors 65n and 66n and the P-type semiconductors 65p and 66p, which are actually covered with an insulating film 41, are indicated by the thick broken lines. In Fig. 2B, a contour of a semiconductor 42 in the light receiver 40, which is actually covered with the insulating film 41, is indicated by the broken line. In Fig. 2C, contours of the seen-though light receiver 40 and midair supporter 50 are indicated by the broken lines.

As illustrated in Figs. 2A to 2C, the infrared sensor 1 includes a semiconductor substrate 10, an insulating layer 20, an infrared light reflection structure 30, a light receiver 40, a midair supporter 50, a thermoelectric converter 60, and a transistor 80. The semiconductor substrate 10 is an example of a substrate. The infrared light reflection structure 30 is an example of a first infrared light reflection structure. The infrared sensor 1 is, for example, an infrared sensor chip formed by using the semiconductor substrate 10.

The semiconductor substrate 10 is a substrate on which the light receiver 40, the midair supporter 50, the thermoelectric converter 60, a peripheral circuit, and others are provided. The semiconductor substrate 10 is, for example, a silicon substrate but may be a semiconductor substrate other than a silicon substrate. A thickness of the semiconductor substrate 10 is, for example, larger than a thickness of the insulating layer 20. The transistor 80 is provided on an upper surface 11 of the semiconductor substrate 10.

The transistor 80 is a metal oxide semiconductor field effect transistor (MOSFET). The transistor 80 includes a source 80s, a drain 80d, a gate 80g, and a well 80w. A gate oxide film is disposed between the gate 80g, which is a conductive layer, and a channel region of the transistor 80. In the present embodiment, the source 80s is an input terminal of the transistor 80, and the drain 80d is an output terminal of the transistor 80. Note that the transistor 80 need not include the well 80w depending on kind and concentration of an impurity in the semiconductor substrate 10.

In the present embodiment, whether or not an infrared light detection signal generated by the thermoelectric converter 60 is output is switched by turning the transistor 80 on/off. In a case where the infrared sensor 1 is used as a pixel of an infrared light imaging device, the transistor 80 serves a pixel selection switch function. Note that the infrared sensor 1 may include another MOSFET provided on the semiconductor substrate 10 in addition to the transistor 80. Such an MOSFET serves, for example, a pixel selection logic function, a detection signal amplification function, or the like.

The insulating layer 20 is located on the upper surface 11 of the semiconductor substrate 10. The insulating layer 20 includes an insulating film 21 located on the semiconductor substrate 10 and an insulating film 22 located on the insulating film 21 on a side opposite to the semiconductor substrate 10. The insulating film 21 and the insulating film 22 are laminated on the upper surface 11 of the semiconductor substrate 10 in this order from the semiconductor substrate 10 side along the thickness direction of the semiconductor substrate 10. The insulating film 21 and the insulating film 22 are, for example, made of an oxide such as silicon oxide (SiO₂), but may be made of an insulating material other than a silicon oxide.

The infrared light reflection structure 30 reflects infrared incident light Lin that has passed through the light receiver 40 toward the light receiver 40. The infrared light reflection structure 30 is provided in the insulating layer 20. The infrared light reflection structure 30 includes metal vias 31 extending in the insulating layer 20 in a thickness direction of the insulating layer 20. Specifically, the metal vias 31 have a pillar shape provided in the insulating film 21, and stand on the semiconductor substrate 10 so as to extend in the insulating film 21 along the thickness direction of the insulating film 21. Each of the metal vias 31 is, for example, made of a high-melting-point metal such as tungsten.

**In** the present embodiment, the metal vias 31 are separated away from each other with the insulating film 21 interposed therebetween. The metal vias 31 are disposed in an array of rows in a longitudinal direction and rows in a lateral direction in plan view. A planar shape of the metal vias 31 is, for example, rectangular but is not limited in particular.

In plan view, a range where the metal vias 31 that constitute the infrared light reflection structure 30 are provided is wider than the light receiver 40.

A thickness (longitudinal and lateral lengths in plan view) of the metal vias 31 is, for example, greater than or equal to 0.5 µm and less than or equal to 1 µm. A distance (a length of a gap in plan view) between two metal vias 31 that are adjacent in the longitudinal direction or a lateral direction in plan view is greater than or equal to 0.5 µm and less than or equal to 1 µm. Accordingly, a pitch at which the metal vias 31 are arranged is greater than or equal to 0.5 µm and less than or equal to 1 µm, which is small, specifically, approximately greater than or equal to 1/10 and less than or equal to 1/5 of a wavelength of received infrared light, which is close to 10 µm. Therefore, the infrared light reflection structure 30 including the metal vias 31 can exhibit reflection characteristics close to the uniformly formed metal reflection film 30X illustrated in Fig. 1 described above.

End surfaces 32 of the metal vias 31 on the semiconductor substrate 10 side (on a lower side) are in contact with the upper surface 11 of the semiconductor substrate 10. End surfaces of the metal vias 31 on an upper side are covered with a thin insulating film but may be exposed to the gap 51.

The light receiver 40 generates heat by absorbing infrared light, and a temperature of the light receiver 40 rises due to this heat. A quantity of heat generated by the light receiver 40 depends on the infrared light absorption amount of the light receiver 40. The light receiver 40 is located above the infrared light reflection structure 30. The light receiver 40 has two-dimensional expanse. A planar shape of the light receiver 40 is, for example, a square, but may be another shape such as an oblong. The light receiver 40 overlaps the infrared light reflection structure 30 in plan view. For example, the whole light receiver 40 is located within a range where the metal vias 31 are provided in plan view. The light receiver 40 and the infrared light reflection structure 30 are separated away from each other, and the gap 51 is provided between the light receiver 40 and the infrared light reflection structure 30.

In the present embodiment, the light receiver 40 includes a part of the insulating film 41 and a part of the semiconductor 42 having a thin-film shape. The light receiver 40 has a structure in which the semiconductor 42 is sandwiched by the insulating film 41.

The insulating film 41 and the semiconductor 42 are disposed above the insulating layer 20. The insulating film 41 is provided on the gap 51 and on the insulating layer 20. The semiconductor 42 is held by the insulating film 41 on upper and lower sides. The N-type semiconductors 65n and 66n and the P-type semiconductors 65p and 66p, which will be described later, are provided in a part of the semiconductor 42. The insulating film 41 is, for example, made of silicon nitride (SiN), but may be made of an insulating material (e.g., a silicon oxide) other than silicon nitride. The semiconductor 42 is, for example, polycrystalline silicon, but may be a semiconductor other than polycrystalline silicon.

The midair supporter 50 supports the light receiver 40 in midair so that the gap 51 is formed between the infrared light reflection structure 30 and the light receiver 40. The gap 51 is located between the light receiver 40 and midair supporter 50 and the semiconductor substrate 10. In the present embodiment, the midair supporter 50 is two arms that couple the light receiver 40 and the insulating layer 20. The midair supporter 50 includes a part of the insulating film 41 and the N-type semiconductors 65n and 66n and the P-type semiconductors 65p and 66p, which are parts of the semiconductor 42. A side wall of the gap 51 is constituted by the insulating film 22 of the insulating layer 20. The gap 51 is, for example, a recessed portion formed in the insulating layer 20 by removing a part of the insulating film 22 of the insulating layer 20. Even if the gap 51 is thus formed by removing the insulating film 22 below the light receiver 40, the light receiver 40 is supported in midair by the midair supporter 50. Movement of heat from the light receiver 40 to the insulating layer 20 and the semiconductor substrate 10 is prevented or reduced by the gap 51, and a decrease in temperature of the light receiver 40 that has risen upon receipt of infrared light is prevented or reduced.

In the infrared sensor 1, the infrared incident light Lin is incident from above, and a part of the infrared incident light Lin is absorbed by the light receiver 40. The infrared incident light Lin that has passed through the light receiver 40 is reflected by upper surfaces of the metal vias 31 after passing the gap 51, and reflected light Lre thus reflected is also absorbed by the light receiver 40. This increases the infrared light absorption amount of the light receiver 40. As a result, the temperature of the light receiver 40 easily rises.

The thermoelectric converter 60 generates an infrared light detection signal on the basis of heat generated by the light receiver 40. The infrared light detection signal is, for example, a voltage signal or a current signal. At least a part of the thermoelectric converter 60 is provided in the midair supporter 50. In the present embodiment, the thermoelectric converter 60 is a thermopile thermoelectric conversion element utilizing the Seebeck effect. The thermoelectric converter 60 includes the hot junction metal electrodes 61 and 62, the cold junction metal electrodes 63p, 63n, 64p, and 64n, the N-type semiconductors 65n and 66n, the P-type semiconductors 65p and 66p, and a metal wire 67.

The hot junction metal electrodes 61 and 62 are located on the light receiver 40. The hot junction metal electrodes 61 and 62 are located close to a connection portion between the light receiver 40 and the midair supporter 50. Note that positions of the hot junction metal electrodes 61 and 62 are not limited in particular, as long as temperatures of the hot junction metal electrodes 61 and 62 change in synchronization with the temperature of the light receiver 40. For example, the hot junction metal electrodes 61 and 62 may be located adjacent to the light receiver 40.

The cold junction metal electrodes 63p, 63n, 64p, and 64n are located outside the light receiver 40 in plan view. The cold junction metal electrodes 63p, 63n, 64p, and 64n are located outside the gap 51 in plan view. The cold junction metal electrodes 63p, 63n, 64p, and 64n are located close to a connection portion between the insulating layer 20 and the midair supporter 50. The hot junction metal electrode 61 and the cold junction metal electrodes 63p and 64n are disposed with one arm of the midair supporter 50 interposed therebetween. The hot junction metal electrode 62 and the cold junction metal electrodes 63n and 64p are disposed with the other arm of the midair supporter 50 interposed therebetween.

The N-type semiconductors 65n and 66n and the P-type semiconductors 65p and 66p are each provided in the insulating film 41. The N-type semiconductors 65n and 66n and the P-type semiconductors 65p and 66p each have a line shape extending along the midair supporter 50. The N-type semiconductor 66n and the P-type semiconductor 65p pass through one arm of the midair supporter 50. The N-type semiconductor 65n and the P-type semiconductor 66p pass through the other arm of the midair supporter 50. The N-type semiconductors 65n and 66n and the P-type semiconductors 65p and 66p are formed by doping the semiconductor 42 with an impurity (e.g., boron (B) or phosphorus (P)).

One end of the N-type semiconductor 66n and one end of the P-type semiconductor 65p are in contact with the hot junction metal electrode 61 and are connected to the hot junction metal electrode 61. The N-type semiconductor 66n and the P-type semiconductor 65p are electrically connected by the hot junction metal electrode 61 and thereby form a hot junction. One end of the N-type semiconductor 65n and one end of the P-type semiconductor 66p are in contact with the hot junction metal electrode 62 and are connected to the hot junction metal electrode 62. The N-type semiconductor 65n and the P-type semiconductor 66p are electrically connected by the hot junction metal electrode 62 and thereby form a hot junction.

The other end of the P-type semiconductor 65p is in contact with the cold junction metal electrode 63p and is connected to the cold junction metal electrode 63p, and thereby forms a cold junction. The other end of the N-type semiconductor 66n is in contact with the cold junction metal electrode 64n and is connected to the cold junction metal electrode 64n, and thereby forms a cold junction. The other end of the P-type semiconductor 66p is in contact with the cold junction metal electrode 64p and is connected to the cold junction metal electrode 64p, and thereby forms a cold junction. The other end of the N-type semiconductor 65n is in contact with the cold junction metal electrode 63n and is connected to the cold junction metal electrode 63n, and thereby forms a cold junction.

Connection between the hot junction metal electrodes 61 and 62 and the cold junction metal electrodes 63p, 63n, 64p, and 64n of the N-type semiconductors 65n and 66n and the P-type semiconductors 65p and 66p is ohmic connection. The N-type semiconductor 66n and the P-type semiconductor 65p that are ohmic-connected to the same hot junction metal electrode 61 constitute a thermocouple. The N-type semiconductor 65n and the P-type semiconductor 66p that are ohmic-connected to the same hot junction metal electrode 62 constitute a thermocouple.

When the light receiver 40 absorbs infrared light and as a result the temperature of the hot junction becomes higher than the temperature of the cold junction, a large number of carriers gather at the cold junction side. As a result, the cold junction of the N-type semiconductors 65n and 66n have a negative electromotive voltage with respect to the cold junction of the P-type semiconductors 65p and 66p. In the example illustrated in Figs. 2A to 2C, there are two pairs of cold junction and hot junction, and the metal wire 67 electrically connects the cold junction metal electrode 64n and the cold junction metal electrode 64p. Accordingly, the two thermocouples having an electromotive voltage are connected in series, and the cold junction metal electrode 63n have a negative electromotive voltage with respect to the cold junction metal electrode 63p. That is, a potential difference according to heat generated by the light receiver 40 occurs between the cold junction metal electrode 63p and the cold junction metal electrode 63n. At this time, the cold junction metal electrode 63n is held at a constant predetermined potential used as a reference, and when the transistor 80 is brought into a conductive state, an infrared light detection signal according to this electromotive voltage is output from the cold junction metal electrode 63p through the transistor 80. The infrared light detection signal is, for example, amplified by an amplifier and is taken out to an outside. Note that as for a temperature relationship between the "hot junction" and the "cold junction" of the thermoelectric converter 60, the temperature of the hot junction is not necessarily higher than the temperature of the cold junction. For example, in a case where the infrared sensor 1 is used to detect a temperature of an object lower than the temperature of the infrared sensor 1 itself, the temperature of the hot junction may be lower than the temperature of the cold junction. In this case, a polarity of the electromotive voltage of the thermoelectric converter 60 is inverted.

The source 80s of the transistor 80 is electrically connected to the metal wire 83 located above the insulating layer 20 by a metal via 81 extending in the insulating layer 20 in the thickness direction of the insulating layer 20. The metal wire 83 is electrically connected to the cold junction metal electrode 63p by the metal wire 71. The drain 80d of the transistor 80 is electrically connected to the metal wire 84 located above the insulating layer 20 by a metal via 82 extending in the insulating layer 20 in the thickness direction of the insulating layer 20. The metal wire 84 is, for example, electrically connected to a terminal for connection with an outside. The metal wire 84 may be the terminal. With this configuration, in a case where the transistor 80 is in a conductive state, the infrared light detection signal generated by the thermoelectric converter 60 is output from the cold junction metal electrode 63p to the outside through the transistor 80.

The hot junction metal electrodes 61 and 62, the cold junction metal electrodes 63p, 63n, 64p, and 64n, the metal wire 67, the metal wire 71, the metal wire 83, and the metal wire 84 are each, for example, made of a metal such as aluminum. The metal vias 81 and 82 are, for example, made of a high-melting-point metal such as tungsten.

Note that the midair supporter 50 may have a phononic crystal structure. For example, a phononic crystal structure is formed in the N-type semiconductors 65n and 66n and the P-type semiconductors 65p and 66p that pass through the midair supporter 50. An artificial phononic crystal structure processed by a semiconductor process is a structure in which fine holes having a diameter in a level of several tens of nm are periodically arranged. The fine holes are, for example, arranged at intervals of greater than or equal to 1 nm and less than or equal to 300 nm. A hole diameter of the fine holes is, for example, greater than or equal to 10 nm and less than or equal to 50 nm.

A wavelength of a phonon that carries heat mainly ranges from 1 nm to 300 nm, and therefore a phononic crystal structure tends to have high heat insulation in a case where the interval is within this range. Electron lithography is suitable for formation of a phononic crystal structure in which an interval is approximately greater than or equal to 100 nm and less than or equal to 300 nm. Block copolymer (BCP) lithography is suitable for formation of a phononic crystal structure in which an interval is approximately greater than or equal to 1 nm and less than or equal to 100 nm. **In** the semiconductor 42 (including a doped region) made of polycrystalline silicon or the like included in the midair supporter 50, a fine through-hole can be dug by using the lithography and dry etching. **In** this case, in a case where an aspect ratio (a hole depth/hole diameter) of the hole is less than or equal to 5, etching gas easily enters the hole, and the hole is easily processed. For example, the etching gas etches a hole of a diameter of 20 nm to perforate a polycrystalline silicon thin film having a thickness of 100 nm, and thereby a phononic crystal structure having a hole diameter of 20 nm can be formed.

Since it is difficult to achieve a balance between a processing shape and productivity in processing of a hole having an aspect ratio of larger than 5, a suitable film thickness of the light receiver 40 for producing a phononic crystal structure is approximately 100 nm at maximum. It may be possible to form a metal thin film having a thickness of several nm on a surface of the light receiver 40 to increase light reception efficiency in matching with impedance of vacuum in a wavelength region of infrared light to be detected. Even in this case, however, the thickness of the light receiver 40 is not markedly different from approximately 100 nm. Using the thin film of the semiconductor 42 for the midair supporter 50 and the light receiver 40, infrared light easily pass therethrough due to the thinness, and therefore the method of returning the reflected light Lre to the light receiver 40 by the infrared light reflection structure 30 and thereby supplementing an infrared light reception amount of the light receiver 40 is effective. Furthermore, in a case where the midair supporter 50 has a phononic crystal structure, heat insulation performance of the midair supporter 50 is increased. This makes it easy to maintain a temperature difference between the hot junction and the cold junction. It is therefore possible to increase sensitivity of the infrared sensor 1. Since the infrared sensor 1 uses the light receiver 40 that is thin and therefore has a small heat capacity, it is also possible to provide the infrared sensor 1 having high-speed response in which a temperature difference between the hot junction and the cold junction can speedily change in response to a change in infrared light power.

### [Method for Producing Infrared Sensor]

Next, a method for producing the infrared sensor 1 according to the present embodiment is described. Note that the production method described below is an example, and a method for producing the infrared sensor 1 is not limited to the following example.

Figs. 3A to 3E are cross-sectional views for explaining a method for producing the infrared sensor 1 according to Embodiment 1.

First, as illustrated in Fig. 3A, the semiconductor substrate 10 on which the transistor 80 is provided is prepared, and the insulating film 21 is formed on the semiconductor substrate 10 by chemical vapor deposition (CVD). The insulating film 21 is, for example, a silicon oxide film. Next, via holes 25 are formed by digging the insulating film 21 by dry etching at positions where the metal vias 31, 81, and 82 are to be formed.

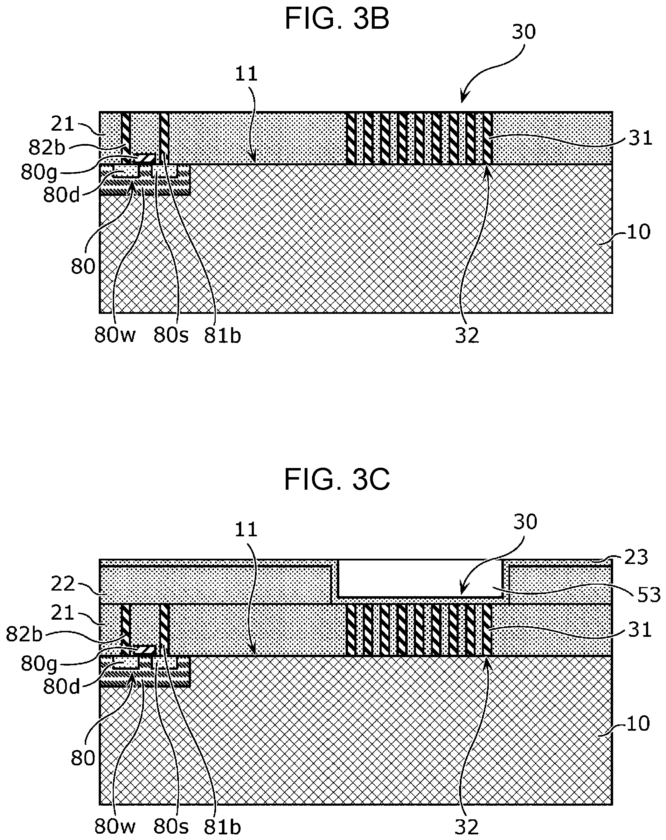

Next, as illustrated in Fig. 3B, tungsten is deposited in the via holes 25 by a process such as a vapor-phase deposition process to form the metal vias 31 on the semiconductor substrate 10, a metal via 81b on the source 80s, and a metal via 82b on the drain 80d. After the deposition of tungsten, upper surfaces of the insulating film 21, the metal vias 31, and the metal vias 81b and 82b are exposed by CMP. Note that in formation of the metal vias 31 and the metal vias 81b and 82b, a film of titanium nitride or the like may be formed as a foundation contact layer before the deposition of tungsten in the via holes 25.

Next, as illustrated in Fig. 3C, the insulating film 22 is formed on the insulating film 21 by CVD. The insulating film 22 is, for example, a silicon oxide film. A recessed space 53 is formed by dry-etching the insulating film 22 in a portion (a portion where the gap 51 is to be formed) located below the light receiver 40 and above the infrared light reflection structure 30 including the metal vias 31. Furthermore, a thin protective film 23 is deposited by CVD on the insulating film 22 in which the recessed space 53 has been formed. The protective film 23 is, for example, a silicon oxide film.

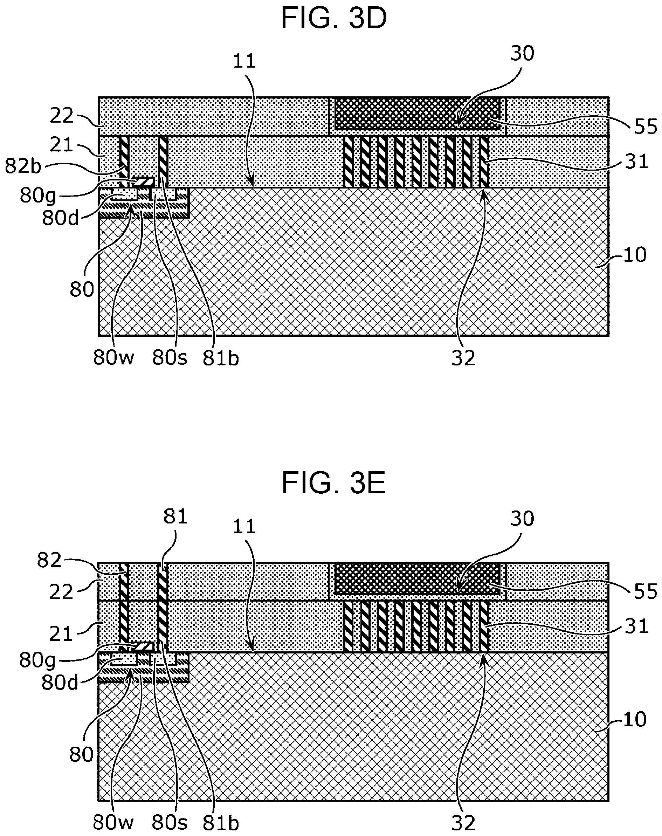

Next, as illustrated in Fig. 3D, a material for a sacrificial layer 55 is deposited to fill the recessed space 53, and upper surfaces of the insulating film 22 and the sacrificial layer 55 are exposed by CMP. The material for the sacrificial layer 55 is, for example, polycrystalline silicon.

Next, as illustrated in Fig. 3E, the metal vias 81 and 82 are formed by dry-etching the insulating film 22 above the metal vias 81b and 82b, putting tungsten, and performing CMP again in a method similar to the method for forming the metal vias 81b and 82b and thereby adding tungsten to the metal vias 81b and 82b.

Then, the gap 51 is formed by removing the sacrificial layer 55 by etching using xenon fluoride (XeF₂) after forming the light receiver 40, the midair supporter 50, the thermoelectric converter 60, and the various metal wires. In this way, the infrared sensor 1 illustrated in Figs. 2A to 2C is obtained. For example, a machining process used for semiconductor device production is used to form the light receiver 40, the midair supporter 50, the thermoelectric converter 60, and the various wires.

As described above, in the method for producing the infrared sensor 1 according to the present embodiment, the infrared light reflection structure 30 using a high-melting-point metal such as tungsten can be formed by a wiring process used in conventional semiconductor device production of filling the via holes 25 with tungsten and then performing a polishing process by CMP. This makes it unnecessary to use dry etching that is used to form a metal reflection film and is said to be poor in productivity, thereby making it possible to produce the infrared sensor 1 while avoiding two-step etching that requires replacement of etching gas. It is therefore possible to improve productivity.

### [Thermal Behavior of Infrared Light Reflection Structure]

In the infrared light reflection structure 30 including the metal vias 31 according to the present embodiment, heat generated in the infrared light reflection structure 30 can be promptly flown away to the semiconductor substrate 10 as compared with an infrared light reflection structure including a metal thin film. A result of calculating this thermal behavior by using a finite element method is described below.

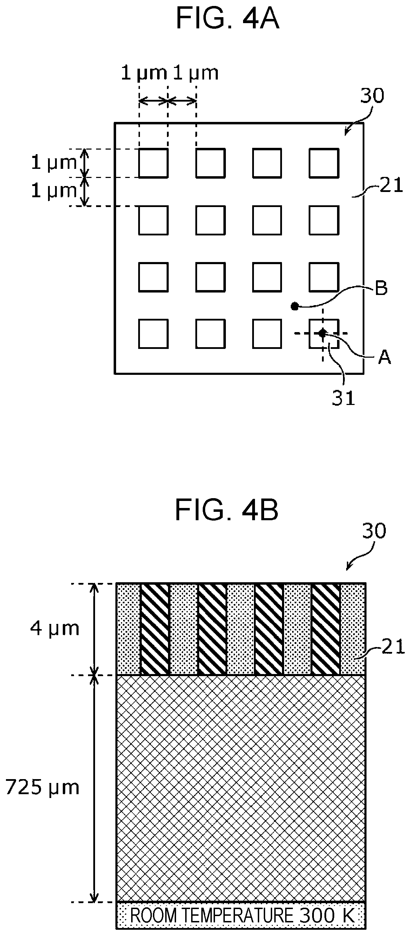

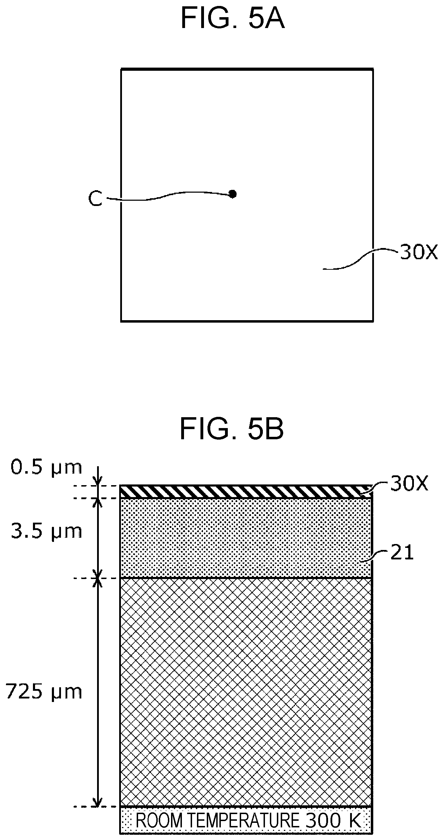

Fig. 4A is a top view of the infrared light reflection structure 30 according to Embodiment 1 used for calculation of thermal behavior. Fig. 4B is a cross-sectional view of the infrared light reflection structure 30 according to Embodiment 1 used for calculation of thermal behavior. Fig. 5A is a top view of an infrared light reflection structure according to a comparative example used for calculation of thermal behavior. Fig. 5B is a cross-sectional view of the infrared light reflection structure according to the comparative example used for calculation of thermal behavior.

First, a structure of each constituent element used for calculation of thermal behavior is described.

As illustrated in Figs. 4A and 4B, the infrared light reflection structure 30 includes the metal vias 31, and a dimension of the metal vias 31 in top view is 1 µm square, and a length of the metal vias 31 in the thickness direction of the insulating film 21 is 4 µm. The metal vias 31 are arranged at intervals of 1 µm on the semiconductor substrate 10 having a thickness of 725 µm, and a gap between the metal vias 31 is filled with the insulating film 21 made of a silicon oxide film. In top view, a ratio of a total area of the metal vias 31 to an area of the surrounding insulating film 21 is 1/3. The thickness of the insulating film 21 is 4 µm.

As illustrated in Figs. 5A and 5B, the metal reflection film 30X, which is the infrared light reflection structure according to the comparative example, is provided so as to cover the whole upper surface of the insulating film 21 and has a thickness of 0.5 µm. The thickness of the insulating film 21 is 3.5 µm. The insulating film 21 is provided on the semiconductor substrate 10 having a thickness of 725 µm.

Next, conditions used for calculation of thermal behavior are described.

As illustrated in Figs. 4B and 5B, a bottom surface of the semiconductor substrate 10 has a room temperature (300 K). The infrared light reflection structure 30 and the metal reflection film 30X are irradiated from above with infrared light that has not been absorbed by the light receiver 40 (not illustrated), and a part of the infrared light is absorbed by the infrared light reflection structure 30 and the metal reflection film 30X to become heat although most of the infrared light is reflected by the infrared light reflection structure 30 and the metal reflection film 30X. It is assumed that generation of heat of 10 nJ/µm³ continues for 10 µs in a thickness of 0.5 µm of a superficial layer. That is, in the structure illustrated in Fig. 4B, it is assumed that a superficial layer portion having a thickness of 0.5 µm of the metal vias 31 and a superficial layer portion having a thickness of 0.5 µm of the insulating film 21 are a source of generation of heat. On the other hand, in the structure illustrated in Fig. 5B, it is assumed that the whole metal reflection film 30X having a thickness of 0.5 µm is a source of generation of heat.

Furthermore, it is assumed that thermal conductivity and specific heat capacity of the metal vias 31 and the metal reflection film 30X are 178 W/(m·K) and 0.13 J/(g·K), respectively. It is assumed that thermal conductivity and specific heat capacity of the insulating film 21 are 1.4 W/(m·K) and 1.0 J/(g·K), respectively. It is assumed that thermal conductivity and specific heat capacity of the semiconductor substrate 10 are 157 W/(m·K) and 0.70 J/(g·K), respectively.

Next, a calculation result of thermal behavior is described.

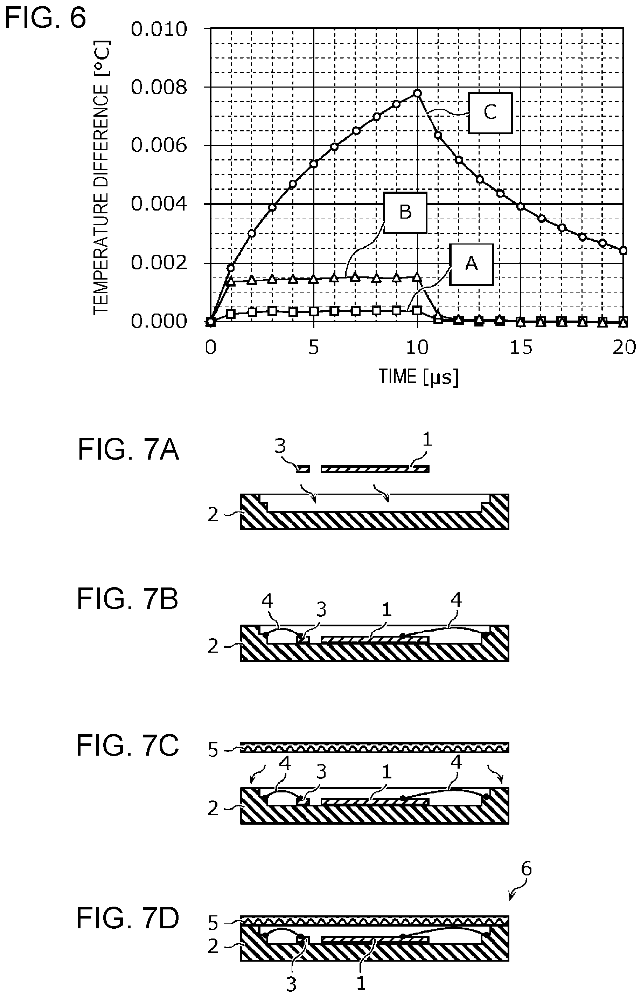

Fig. 6 illustrates a calculation result of temperature changes in the infrared light reflection structures according to Embodiment 1 and the comparative example. Fig. 6 illustrates a calculation result of temperature changes at points A to C illustrated in Figs. 4A and 5A during 10 µs where heat is generated upon irradiation of infrared light and subsequent 10 µs where no infrared light is applied. The point A is a center point of the upper surface of one of the metal vias 31. The point B is a point on the upper surface of the insulating film 21 that is farthest from four metal vias 31 arranged in two rows and two columns. The point C is a center point of the upper surface of the metal reflection film 30X. The vertical axis of Fig. 6 is a difference between a temperature at each of the points A, B, and C and an average temperature on the surface of the semiconductor substrate 10. The horizontal axis of Fig. 6 is a time assuming that start of irradiation of infrared light is 0 µs.

As illustrated in Fig. 6, the temperature of the metal reflection film 30X at the point C rises by approximately + 0.008 °C during initial 10 µs where heat is generated. On the other hand, the infrared light reflection structure 30 using the metal vias 31 has a higher effect of flowing heat to the semiconductor substrate 10 due to the metal vias 31. Specifically, rise in temperature of the metal vias 31 at the point A during the initial 10 µs where heat is generated is kept less than + 0.0005 °C. Furthermore, rise of the temperature of the insulating film 21 at the point B is kept at approximately + 0.0015 °C. It can be said that this result reflects the effect of the metal vias 31 of flowing heat of the insulating film 21 away to the semiconductor substrate 10.

It can be said from the above result illustrated in Fig. 6 that the infrared light reflection structure 30 using the metal vias 31 have the following two characteristics.

The first characteristic lies in that the infrared light reflection structure 30 is small in temperature rise caused by absorption of infrared light and keeps a temperature almost equal to the temperature of the semiconductor substrate 10. Specifically, the temperature rises at the point A and the point B due to generation of heat, but the rise in temperature is slight, and a degree of the rise is remarkably smaller that at the point C. This indicates that the temperature of the infrared light reflection structure 30 can also be grasped by grasping the temperature of the semiconductor substrate 10 by a temperature sensor such as a thermistor. For example, by grasping influence given by the temperature of the infrared light reflection structure 30 on the temperature of the light receiver 40 due to radiation in advance, the influence can be corrected during actual operation of the infrared sensor 1.

The second characteristic lies in that the temperature change of the infrared light reflection structure 30 is speedy. Specifically, the temperature change at the point C is not saturated during the initial 10 µs where heat is generated and is not fully mitigated during latter 10 µs where no heat is generated, whereas the temperature changes at the point A and the point B shift to a steady state in approximately 2 µs. For example, it is assumed that (N - 1)th sampling is performed at the time 0 µs, and N-th sampling is performed at a time 20 µs. In this case, at the point C of the metal reflection film 30X, the past temperature rise remains without fully disappearing at the N-th sampling. Accordingly, infrared light detection information obtained by the N-th sampling is influenced by the remaining temperature rise of the metal reflection film 30X due to radiation. The temperature of the metal reflection film 30X that has risen cannot be grasped by a temperature sensor such as a thermistor, and influence of the temperature rise cannot be removed by correction, unlike the temperature of the semiconductor substrate 10. On the other hand, in the infrared light reflection structure 30 using the metal vias 31, the temperature rise of the infrared light reflection structure 30 that occurred during the initial 10 µs has been fully mitigated and disappeared at the N-th sampling, and therefore influence of the temperature rise does not appear as an error in infrared light detection information obtained by the sampling.

Note that as the ratio of the total area of the metal vias 31 to the area of the surrounding insulating film 21 becomes larger than 1/3, the above effect becomes higher.

Due to the above two characteristics, the temperature of the infrared light reflection structure 30 using the metal vias 31 can be regarded as being identical to the temperature of the semiconductor substrate 10, and the temperature of the infrared light reflection structure 30 can be grasped by grasping the temperature of the semiconductor substrate 10.

### [Correction of Detection Result of Infrared Sensor]

Next, correction of a detection result of the infrared sensor 1 is described. As described above, in the infrared sensor 1, influence of the temperature of the infrared light reflection structure 30 can be corrected.

First, an infrared sensor package on which the infrared sensor 1 is mounted is described. For example, the infrared sensor 1 is mounted on a package together with a thermistor chip. This makes it possible to grasp the temperature of the semiconductor substrate 10 from a temperature indicated value of the thermistor chip. Figs. 7A to 7D are cross-sectional views for explaining a step of mounting the infrared sensor 1 according to Embodiment 1 on a package 2. In Figs. 7A to 7D, details of a wire running from an inside to an outside of the package 2, a structure of the infrared sensor 1, and the like are not illustrated.

As illustrated in Fig. 7A, a thermistor chip 3 and the infrared sensor 1 are die-attached in proximity to each other to a bottom surface of a cavity provided in the package 2. In this process, the bottom surface of the cavity of the package 2 is metalized, and a rear surface of the thermistor chip 3 and a rear surface of the infrared sensor 1 are also metalized, and these are die-attached with a paste agent having good thermal conductivity. Temperatures of three portions, specifically, the semiconductor substrate 10 of the infrared sensor 1, the thermistor chip 3, and the bottom surface of the cavity of the package 2 can be thus made almost identical. The package 2 is, for example, a ceramic package.

Next, as illustrated in Fig. 7B, wire connection necessary for driving the thermistor chip 3 and the infrared sensor 1 is performed by using a bonding wire 4. Then, as illustrated in Figs. 7C and 7D, a lid 5 is disposed so as to seal the cavity of the package 2. Examples of a material for the lid 5 include glass, germanium, and anti-reflection (AR)-coated silicon, which have good transmittance of a wavelength close to a wavelength 10 nm of infrared light. The lid 5 and the package 2 are joined by AuSn joining or the like.

Through the above steps, an infrared sensor package 6 is obtained. The infrared sensor package 6 includes, for example, the infrared sensor 1, the thermistor chip 3 that measures a temperature of the semiconductor substrate 10 of the infrared sensor 1, the package 2 having a cavity in which the infrared sensor 1 and the thermistor chip 3 are stored, and the lid 5 that seals the cavity of the package 2. Instead of the infrared sensor 1, the infrared sensor package 6 may include an infrared light imaging device including an infrared sensor array in which the infrared sensors 1 that share the semiconductor substrate 10 are arranged in an array.

The infrared sensor package 6 in which the infrared sensor 1 is mounted also includes the thermistor chip 3. The temperature indicated value of the thermistor chip 3 can be regarded as being identical to the temperature of the semiconductor substrate 10 of the infrared sensor 1 disposed close in the package 2. As a result, the temperature indicated value of the thermistor chip 3 can also be regarded as being identical to the temperature of the infrared light reflection structure 30 including the metal vias 31 standing in contact with the semiconductor substrate 10 serving as a hot bath.

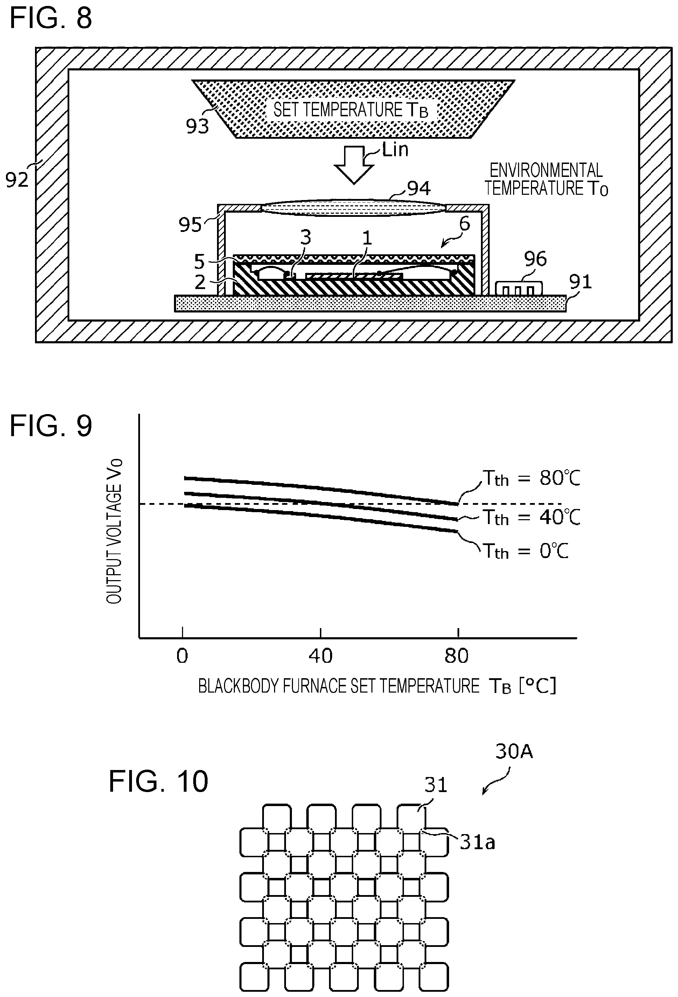

Next, correction of an infrared light detection signal of the infrared sensor 1 is described. By grasping the temperature of the semiconductor substrate 10 by a temperature meter such as a thermistor, the temperature of the infrared light reflection structure 30 is also known, and influence given by the temperature of the infrared light reflection structure 30 on the temperature of the light receiver 40 through radiation can be grasped in advance. As a result, correction for removing a component that is included in the infrared light detection signal of the infrared sensor 1 and depends on the temperature of the infrared light reflection structure 30 can be performed. Specifically, a temperature correction step is performed by controlling the temperature of the semiconductor substrate 10 regarded as a hot bath in a state where the light receiver 40 is irradiated with infrared light of constant power and measuring an infrared light detection signal based on electromotive force generated in the thermoelectric converter 60. The temperature of the semiconductor substrate 10 is grasped by a temperature sensor such as a thermistor and is controlled to any temperature. When the temperature of the semiconductor substrate 10 and the temperature of the infrared light reflection structure 30 equal to the temperature of the semiconductor substrate 10 fluctuate even if power of the applied infrared light remains the same, the electromotive force of the thermoelectric converter 60 also fluctuates. By grasping this fluctuation, a correction coefficient necessary for estimating the infrared light power from the electromotive force of the thermoelectric converter 60 can be obtained. The temperature correction step is described in detail below with reference to Figs. 8 and 9.

Fig. 8 is a cross-sectional view illustrating setup for obtaining a correction coefficient for correcting the infrared light detection signal. As illustrated in Fig. 8, the infrared sensor package 6 illustrated in Fig. 7D is mounted on the substrate 91 and is installed in a constant-temperature bath 92. Furthermore, a blackbody furnace 93 is installed in the constant-temperature bath 92. The blackbody furnace 93 is disposed so that an irradiation surface thereof faces the infrared sensor 1. The blackbody furnace 93 irradiates the infrared sensor 1 with infrared incident light Lin. A lens 94 that transmits infrared light is provided between the blackbody furnace 93 and the infrared sensor package 6. The lens 94 is fixed to the substrate 91 with a housing 95 for attaching the lens 94 interposed therebetween. By the lens 94, the infrared sensor 1 forms an image on the irradiation surface of the blackbody furnace 93 having a uniform temperature with predetermined viewing angle and distance. On the substrate 91, an amplification integrated circuit (IC) 96 that amplifies the infrared light detection signal of the infrared sensor 1 is mounted.

When an environmental temperature T₀ in the constant-temperature bath 92 is changed, a temperature indicated value Tₜₕ of the thermistor chip 3 changes. The temperature indicated value Tₜₕ indicates the temperature of the semiconductor substrate 10 of the infrared sensor 1, that is, the temperature of the hot bath. Fig. 9 illustrates an example of a relationship between a set temperature of the blackbody furnace 93 and the infrared light detection signal. Fig. 9 illustrates a relationship between a set temperature of the blackbody furnace 93 and the infrared light detection signal in cases where the temperature indicated value Tₜₕ of the thermistor chip 3 is 0°C, 40°C, and 80°C. The vertical axis of Fig. 9 is an output voltage V₀ of the amplifier IC 96 that has amplified the infrared light detection signal. The horizontal axis of Fig. 9 is a set temperature T_{B} of the blackbody furnace 93.

As illustrated in Fig. 9, in a case where the temperature indicated value Tₜₕ varies due to influence of the environmental temperature T₀, an obtained value of the infrared light detection signal also varies even if infrared light is emitted from the blackbody furnace 93 of the same set temperature T_{B}. By storing, for each temperature indicated value Tₜₕ, the relationship between the infrared light detection signal and the set temperature T_{B} illustrated in Fig. 9 as a formula or a table, a temperature of a subject can be estimated by referring to a value of the temperature indicated value Tₜₕ obtained from the thermistor chip 3. Note that since the temperature of the semiconductor substrate 10 indicated by the temperature indicated value Tₜₕ indicates the temperature of the infrared light reflection structure 30 including the metal vias 31, influence given by the temperature of the infrared light reflection structure 30 on the temperature of the light receiver 40 through radiation is corrected in the estimated temperature of the subject corrected by using the formula or the table.

In the infrared sensor 1, the temperature of the infrared light reflection structure 30 easily settles into a temperature equal to the temperature of the semiconductor substrate 10 within a sufficiently short period relative to a sampling interval of the infrared light detection signal, and therefore the temperature difference between the infrared light reflection structure 30 and the semiconductor substrate 10 is small and the temperatures of the infrared light reflection structure 30 and the semiconductor substrate 10 can be regarded as being identical. Through the above temperature correction step, it is therefore possible to provide a high-precision infrared sensor 1 that can remove an error given by the temperature of the infrared light reflection structure 30 on the temperature of the light receiver 40 through radiation by using a measurement value of the temperature of the semiconductor substrate 10 during actual operation of the infrared sensor 1. Furthermore, it is possible to provide a high-precision infrared light imaging device using the infrared sensor 1.

Note that although the thermistor chip 3 is used as the temperature sensor that measures the temperature of the semiconductor substrate 10 in the above description, the temperature sensor is not limited to this. As the temperature sensor, a bandgap temperature sensor obtained by embedding a pn junction in the same semiconductor substrate 10 as the infrared sensor 1 may be used.

As described above, the infrared sensor 1 according to the present embodiment includes the semiconductor substrate 10, the insulating layer 20 located on the upper surface 11 of the semiconductor substrate 10, the infrared light reflection structure 30 provided in the insulating layer 20, the light receiver 40 located above the infrared light reflection structure 30, the midair supporter 50 that supports the light receiver 40 in midair so that a gap is formed between the infrared light reflection structure 30 and the light receiver 40, and the thermoelectric converter 60 that generates an infrared light detection signal on the basis of heat generated in the light receiver 40. The infrared light reflection structure 30 includes the metal vias 31 extending in the insulating layer 20 in the thickness direction of the insulating layer 20.

With this configuration, the infrared incident light Lin that has passed through the light receiver 40 and passed the gap is reflected by the infrared light reflection structure 30 and is absorbed as reflected light Lre by the light receiver 40. This makes it possible to increase the infrared light absorption amount of the light receiver 40. Therefore, an infrared light detection signal generated by the thermoelectric converter 60 on the basis of heat of the light receiver 40 increases, and S/N can be improved.

The temperature of the infrared light reflection structure 30 can rise by absorbing infrared light, and therefore in a case where the temperature rises, the temperature rise influences the temperature of the light receiver 40 through radiation or the like. In the infrared sensor 1, the infrared light reflection structure 30 includes the metal vias 31 extending in the insulating layer 20 on the semiconductor substrate 10 in the thickness direction of the insulating layer 20, and therefore the metal vias 31 can be brought into contact with the semiconductor substrate 10 or brought closer to the semiconductor substrate 10 than in a case of the metal reflection film 30X. Accordingly, heat of the metal vias 31 easily moves to the semiconductor substrate 10 that can be regarded as a hot bath whose heat capacity is large and whose temperature is hard to change. That is, a temperature deviation between the metal vias 31 and the semiconductor substrate 10 is small, and the infrared light reflection structure 30 promptly fits into the temperature of the semiconductor substrate 10. Accordingly, the temperature of the infrared light reflection structure 30 is hard to change and gives less influence to the temperature of the light receiver 40, and therefore an error of the infrared light detection signal generated by the thermoelectric converter 60 can be reduced.

Furthermore, since the metal vias 31 are in contact with or close to the semiconductor substrate 10, the temperature of the metal vias 31 promptly fits into the semiconductor substrate 10, and the temperature of the metal vias 31 can be regarded as being identical to the temperature of the semiconductor substrate 10. Therefore, when the temperature of the semiconductor substrate 10, which can be easily grasped, is grasped, the temperature of the metal vias 31 that is harder to grasp is also known. Therefore, by grasping the temperature of the semiconductor substrate 10, influence of the temperature of the metal vias 31 on the light receiver 40 can be corrected, and an error of the infrared light detection signal can be reduced more.

According to the infrared sensor 1 according to the present embodiment, it is therefore possible to increase infrared light detection accuracy.

In the infrared sensor 1, the metal vias 31 are in contact with the semiconductor substrate 10, and therefore heat of the metal vias 31 easily transmits to the semiconductor substrate 10. Therefore, even if external disturbance of a temperature is applied to the infrared light reflection structure 30 including the metal vias 31, the temperature of the infrared light reflection structure 30 can be more promptly brought close to a temperature identical to the temperature of the semiconductor substrate 10.

### [Modification]

Although the metal vias 31 are separated away from each other in the infrared light reflection structure 30 described above, this is not restrictive. Parts of outer peripheries of the metal vias 31 in plan view may be connected.

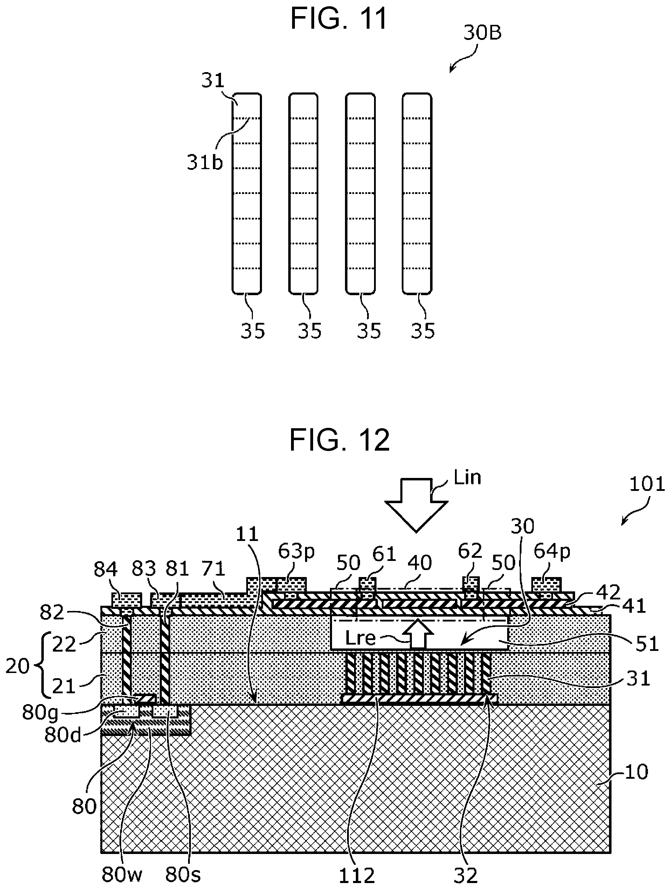

Fig. 10 is a plan view of an infrared light reflection structure 30A according to Modification 1 of Embodiment 1 viewed from above. Fig. 11 is a plan view of an infrared light reflection structure 30B according to Modification 2 of Embodiment 1 viewed from above. In Figs. 10 and 11, illustration of members other than the infrared light reflection structure is omitted.

The infrared sensor 1 according to the present embodiment may include the infrared light reflection structure 30A or the infrared light reflection structure 30B instead of the infrared light reflection structure 30. Note that infrared sensors according to embodiments below other than Embodiment 1 may also include the infrared light reflection structure 30A or the infrared light reflection structure 30B instead of the infrared light reflection structure 30.

As illustrated in Fig. 10, the metal vias 31 that constitute the infrared light reflection structure 30A are not separated away from each other, and parts of outer peripheries of the metal vias 31 in plan view are connected to each other. Specifically, in plan view, a corner portion of each of the metal vias 31 is connected to a corner portion of an adjacent metal via 31 to form a connection portion 31a (shared portion).

As illustrated in Fig. 11, the metal vias 31 that constitute the infrared light reflection structure 30B are not separated away from each other, and parts of outer peripheries of the metal vias 31 in plan view are connected to each other. Specifically, in plan view, a side of each of the metal vias 31 is connected to a side of an adjacent metal via 31 to form a connection portion 31b. In the infrared light reflection structure 30B, two or more of the metal vias 31 are connected to each other in a line along a predetermined direction. Accordingly, the two or more metal vias constitute a plate-shaped metal via 35. In the example illustrated in Fig. 11, the infrared light reflection structure 30B includes metal vias 35. Each of the metal vias 35 extends in the insulating layer 20 in the thickness direction of the insulating layer 20 although this is not illustrated.

In the infrared light reflection structures 30A and 30B illustrated in Figs. 10 and 11, a ratio of an area occupied by the metal vias 31 to an area occupied by the insulating layer 20 in plan view is easily increased. Therefore, in the infrared light reflection structures 30A and 30B, infrared light reflectivity is increased more, and the infrared light absorption amount of the light receiver 40 can be increased.

Furthermore, since the ratio of the area occupied by the metal vias 31 to the area occupied by the insulating layer 20 increases, the effect of fitting the temperature of the metal vias 31 and the temperature of the insulating layer 20 around the metal vias 31 into the temperature of the semiconductor substrate 10 increases.

It is therefore possible to further increase infrared light detection accuracy by using the infrared light reflection structure 30A or 30B in the infrared sensor 1.

Furthermore, since only parts of outer peripheries of the metal vias 31 are connected, the infrared light reflection structures 30A and 30B illustrated in Figs. 10 and 11 can be formed by a via formation step used in conventional semiconductor device production of embedding tungsten or the like and performing a polishing process by CMP without using dry etching that is said to be poor in productivity, as in the case of the infrared light reflection structure 30.

### (Embodiment 2)

Next, an infrared sensor according to Embodiment 2 is described. In the following description, differences from Embodiment 1 are mainly described, and description of common points is omitted or simplified.

Fig. 12 is a cross-sectional view illustrating an infrared sensor 101 according to Embodiment 2. Fig. 12 illustrates a cross section of the infrared sensor 101 taken at a position similar to Fig. 2A. As illustrated in Fig. 12, the infrared sensor 101 according to the present embodiment further includes a gate electrode 112 located on an upper surface 11 of a semiconductor substrate 10, unlike the infrared sensor 1 according to Embodiment 1.

The gate electrode 112 includes, for example, a gate polycrystalline silicon layer and a gate oxide film located between the gate polycrystalline silicon layer and the semiconductor substrate 10. The gate electrode 112 has a structure corresponding to a gate electrode of an MOSFET.

In the infrared sensor 101, end surfaces 32 of metal vias 31 on the semiconductor substrate 10 side are in contact with the gate electrode 112. The metal vias 31 are thermally connected to the semiconductor substrate 10 with the gate electrode 112 interposed therebetween.

In the infrared sensor 101, the metal vias 31 are joined to the semiconductor substrate 10 with the thin gate oxide film of the gate electrode 112 interposed therebetween, and therefore heat of the metal vias 31 easily transmits to the semiconductor substrate 10. Therefore, even in a case where external disturbance of a temperature is applied to an infrared light reflection structure 30 including the metal vias 31, a temperature of the infrared light reflection structure 30 can be more promptly brought close to a temperature identical to the temperature of the semiconductor substrate 10.

### (Embodiment 3)

Next, an infrared sensor according to Embodiment 3 is described. In the following description, differences from Embodiments 1 and 2 are mainly described, and description of common points is omitted or simplified.

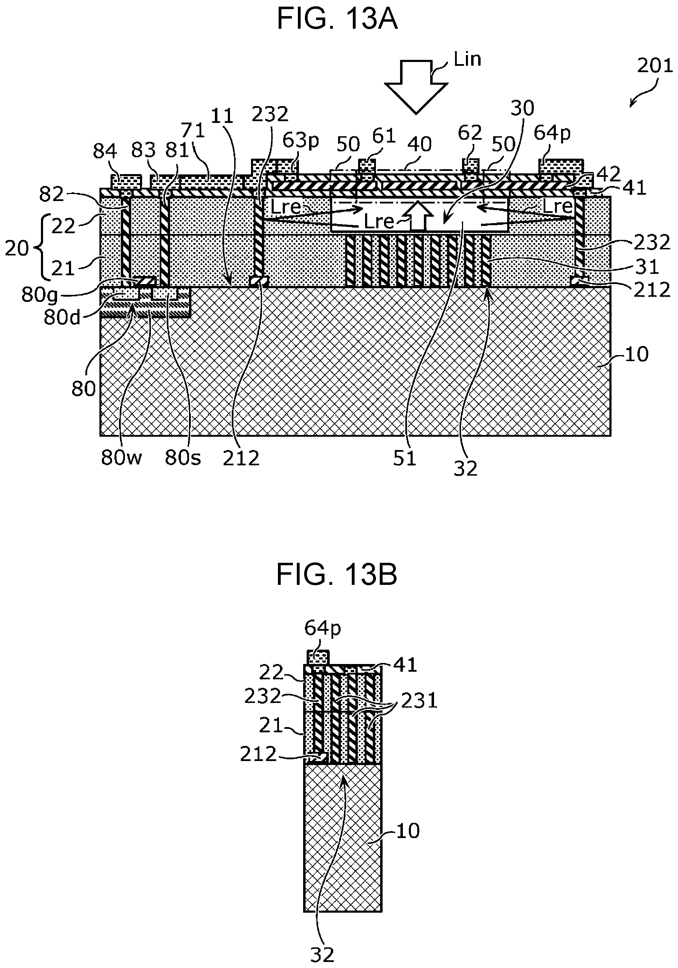

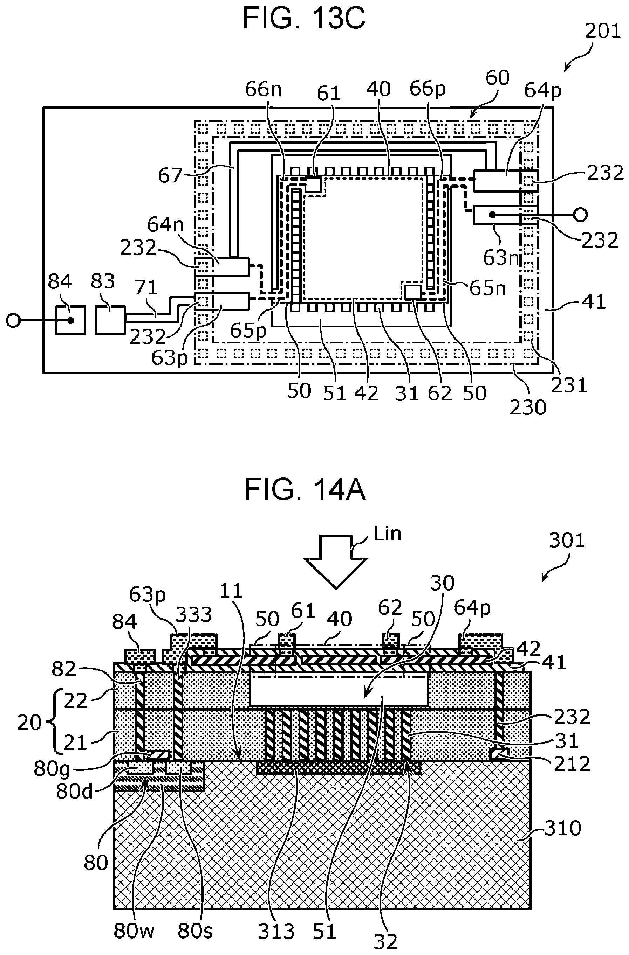

Fig. 13A is a cross-sectional view illustrating an infrared sensor 201 according to Embodiment 3. Fig. 13B is a cross-sectional view illustrating a part of an infrared light reflection structure 230 included in the infrared sensor 201 according to Embodiment 3. Fig. 13C is a plan view of the infrared sensor 201 according to Embodiment 3 viewed from above. Fig. 13A illustrates a cross section taken along a line passing a metal wire 84, a metal wire 83, a metal wire 71, a cold junction metal electrode 63p, a P-type semiconductor 65p, a hot junction metal electrode 61, a hot junction metal electrode 62, a P-type semiconductor 66p, and a cold junction metal electrode 64p in this order in the infrared sensor 201 illustrated in Fig. 13C. Fig. 13B illustrates a part of a cross section of the infrared sensor 201 taken along the infrared light reflection structure 230 close to the cold junction metal electrode 64p. In Fig. 13C, positions of N-type semiconductors 65n and 66n and the P-type semiconductors 65p and 66p, which are actually covered with an insulating film 41, are indicated by the thick broken lines. In Fig. 13C, a contour of a semiconductor 42 in a light receiver 40 and contours of metal vias 231 and 232 that constitute the infrared light reflection structure 230, which are actually covered with the insulating film 41 and others, are indicated by the broken lines.

As illustrated in Figs. 13A to 13C, the infrared sensor 201 according to the present embodiment further includes the infrared light reflection structure 230 and a gate electrode 212 on a semiconductor substrate 10, unlike the infrared sensor 1 according to Embodiment 1. The infrared light reflection structure 230 is an example of a second infrared light reflection structure.

The infrared light reflection structure 230 is disposed so as to surround the light receiver 40 and a gap 51 in plan view. The infrared light reflection structure 230 includes the metal vias 231 and 232. Each of the metal vias 231 and 232 is, for example, made of a high-melting-point metal such as tungsten. The metal vias 231 and 232 are located beside the gap 51 (in a direction perpendicular to an up-down direction).

The metal vias 231 and 232 are arranged in a rectangular ring shape so as to surround the light receiver 40 and the gap 51 in plan view. Note that the arrangement of the metal vias 231 and 232 is not limited to the rectangular ring shape and may be another shape. There may be a portion (e.g., one or two sides of the rectangle) of the ring shape where the metal vias 231 and 232 are not disposed. Although the metal vias 231 and 232 are arranged in one line in a longitudinal direction or a lateral direction, the metal vias 231 and 232 may be arranged in two or more lines.

The metal vias 231 and 232 extend in an insulating layer 20 so as to extend in a thickness direction of the insulating layer 20. The metal vias 231 and 232 are provided in the insulating layer 20 so as to extend throughout a region from an insulating film 21 to an insulating film 22. In the present embodiment, the metal vias 231 and 232 are separated away from each other with the insulating films 21 and 22 interposed therebetween. Note that parts of outer peripheries of the metal vias 231 and 232 in plan view may be connected to each other.

A thickness (longitudinal and lateral lengths in plan view) of each of the metal vias 231 and 232 is, for example, greater than or equal to 0.5 µm and less than or equal to 1 µm. A distance (a length of a gap in plan view) between adjacent two metal vias 231 or adjacent two metal vias 231 and 232 is, for example, greater than or equal to 0.5 µm and less than or equal to 1 µm. Accordingly, a pitch at which the metal vias 231 and 232 are arranged is greater than or equal to 0.5 µm and less than or equal to 1 µm, which is small, specifically, approximately greater than or equal to 1/10 and less than or equal to 1/5 of a wavelength of received infrared light, which is close to 10 µm. Therefore, the infrared light reflection structure 230 including the metal vias 231 and 232 can exhibit optical characteristics close to a uniformly formed metal reflection film.

Infrared incident light Lin is reflected toward an incident direction by an infrared light reflection structure 30, but a part of the infrared incident light Lin is also reflected toward a position beside the gap 51. The infrared light reflection structure 230 reflects reflected light Lre thus reflected toward the position beside the gap 51, and this reflected light Lre is also absorbed by the light receiver 40. It is therefore possible to increase an infrared light absorption amount of the light receiver 40.

In a case where the infrared sensors 201 arranged in an array are used in an infrared light imaging device, the infrared light reflection structure 230 can reflect at least a part of the reflected light Lre reflected toward the position beside the gap 51 so that the at least a part of the reflected light Lre does not enter an adjacent infrared sensor 201. That is, in the infrared light imaging device, mixture of infrared light detection information between adjacent pixels can be prevented or reduced.

The infrared light reflection structure 230 includes the metal vias 232, which are in contact with the cold junction metal electrodes 63p, 63n, 64p, and 64n, and the metal vias 231, which are not in contact with the cold junction metal electrodes 63p, 63n, 64p, and 64n. Upper end surfaces of the metal vias 232 are in contact with the cold junction metal electrodes 63p, 63n, 64p, and 64n, and upper end surfaces of the metal vias 231 are in contact with the insulating film 41.

The metal vias 232, which are in contact with the cold junction metal electrodes 63p, 63n, 64p, and 64n, stabilize temperatures of the cold junction metal electrodes 63p, 63n, 64p, and 64n to a temperature equal to a temperature of the semiconductor substrate 10 that can be regarded as a hot bath and stabilize a temperature difference between the cold junction metal electrodes 63p, 63n, 64p, and 64n and the hot junction metal electrodes 61 and 62 on the light receiver 40.

End surfaces of the metal vias 232 on the semiconductor substrate 10 side are in contact with the gate electrode 212 located between the metal vias 232 and the semiconductor substrate 10. The gate electrode 212 includes, for example, a gate polycrystalline silicon layer and a gate oxide film located between the gate polycrystalline silicon layer and the semiconductor substrate 10. The gate electrode 212 has a structure corresponding to a gate electrode of an MOSFET. The metal vias 232 are connected to the semiconductor substrate 10 serving as a hot bath with the gate polycrystalline silicon layer and the gate oxide film of the gate electrode 212 interposed therebetween. The gate oxide film is interposed in order to prevent or reduce leakage of a weak infrared light detection signal to the semiconductor substrate 10 through the cold junction metal electrodes 63p, 63n, 64p, and 64n. The gate oxide film has low thermal conductivity but is thin and therefore has low thermal resistance. For example, it is assumed that a length of the metal vias 232 in the thickness direction of the insulating layer 20 and thermal conductivity of the metal vias 232 are 4 µm and 178 W/(m·K), respectively, a thickness and thermal conductivity of the gate polycrystalline silicon layer are 0.13 µm and 32 W/(m·K), respectively, and a thickness and thermal conductivity of the gate oxide film are 0.005 µm and 1.4 W/(m·K), respectively. **In** this case, thermal resistance from the upper surfaces of the metal vias 232 to the semiconductor substrate 10 through the gate electrode 212 can be suppressed to an increase of approximately 30% as compared with a case where no gate electrode 212 is provided and the metal vias 232 are in contact with the semiconductor substrate 10.

End surfaces, on the semiconductor substrate 10 side, of the metal vias 231, which are not in contact with the cold junction metal electrodes 63p, 63n, 64p, and 64n, are in contact with the semiconductor substrate 10, as illustrated in Fig. 13B. Note that the metal vias 231 need not necessarily be in contact with the semiconductor substrate 10. For example, the gate electrode 212 may be disposed between the metal vias 231 and the semiconductor substrate 10. The metal vias 231 may be provided only in the insulating film 22 of the insulating layer 20.

Note that the infrared light reflection structure 230 need not necessarily include the metal vias 232.

### (Embodiment 4)

Next, an infrared sensor according to Embodiment 4 is described. In the following description, differences from Embodiments 1 to 3 are mainly described, and description of common points is omitted or simplified.

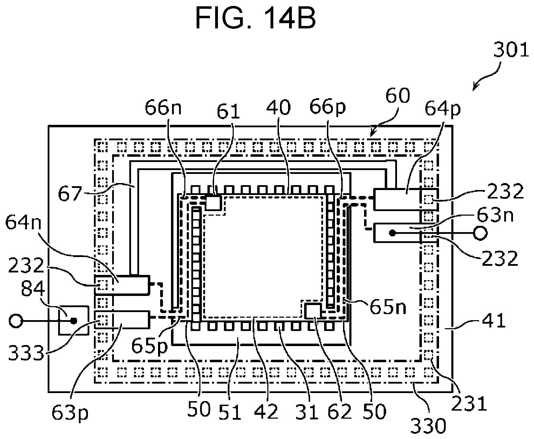

Fig. 14A is a cross-sectional view illustrating an infrared sensor 301 according to Embodiment 4. Fig. 14B is a plan view of the infrared sensor 301 according to Embodiment 4 viewed from above. Fig. 14A illustrates a cross section taken along a line passing a metal wire 84, a cold junction metal electrode 63p, a P-type semiconductor 65p, a hot junction metal electrode 61, a hot junction metal electrode 62, a P-type semiconductor 66p, and a cold junction metal electrode 64p in this order in the infrared sensor 301 illustrated in Fig. 14B. In Fig. 14B, positions of N-type semiconductors 65n and 66n and the P-type semiconductors 65p and 66p, which are actually covered with an insulating film 41, are indicated by the thick broken lines. In Fig. 14B, a contour of a semiconductor 42 in a light receiver 40 and contours of metal vias 231, 232, and 233 that constitute an infrared light reflection structure 330, which are actually covered with the insulating film 41 and others, are indicated by the broken lines.

As illustrated in Figs. 14A and 14B, the infrared sensor 301 according to the present embodiment includes a semiconductor substrate 310 obtained by forming a high-concentration impurity region 313 in the semiconductor substrate 10 instead of the semiconductor substrate 10, unlike the infrared sensor 201 according to Embodiment 3. Furthermore, the infrared sensor 301 includes the infrared light reflection structure 330 instead of the infrared light reflection structure 230, unlike the infrared sensor 201 according to Embodiment 3. Furthermore, the infrared sensor 301 does not include the metal wires 71 and 83 and the metal via 81, unlike the infrared sensor 201 according to Embodiment 3. The infrared light reflection structure 330 is an example of a second infrared light reflection structure. The semiconductor substrate 310 is an example of a substrate.

In the infrared sensor 301, end surfaces 32, on a semiconductor substrate 310 side, of metal vias 31 that constitute an infrared light reflection structure 30 located below the light receiver 40 are in contact with the high-concentration impurity region 313 doped with an impurity at a high concentration in the semiconductor substrate 310. The high-concentration impurity region 313 of the semiconductor substrate 310 is located in an upper end portion of the semiconductor substrate 310 and is located below the infrared light reflection structure 30.

An impurity concentration of the high-concentration impurity region 313 is higher than that of a portion of the semiconductor substrate 310 that is located below the high-concentration impurity region 313. The impurity concentration of the high-concentration impurity region 313 is, for example, greater than or equal to 10¹⁹ cm⁻³ and less than or equal to 10²¹ cm⁻³. This is intended to utilize a property described in Non Patent Literature 1, specifically, a property such that a silicon substrate doped with boron (B) as an impurity at a high concentration of approximately 10²⁰ cm⁻³ exhibits higher infrared light reflectivity, for example, than a non-doped silicon substrate. The inventors of the present invention found that this property can be applied to the infrared sensor 301 according to the present embodiment. That is, infrared incident light Lin that has not been reflected by the metal vias 31 and has passed through the metal vias 31 can be reflected by a surface of the high-concentration impurity region 313 of the semiconductor substrate 310 and returned to the light receiver 40. It is therefore possible to increase an infrared light absorption amount of the light receiver 40.

The infrared light reflection structure 330 includes the metal vias 231, 232, and 333. Specifically, the infrared light reflection structure 330 includes the metal via 333 instead of the metal via 232 that is in contact with the cold junction metal electrode 63p in the infrared light reflection structure 230 according to Embodiment 3. An upper end surface of the metal via 333 is connected to the cold junction metal electrode 63p. A lower end surface of the metal via 333 is connected to a source 80s of a transistor 80. That is, the metal via 333, which is a structure for stabilizing a temperature of the cold junction metal electrode 63p to a temperature equal to a temperature of the semiconductor substrate 310 by connecting the cold junction metal electrode 63p to the semiconductor substrate 310 that can be regarded as a hot bath as described in Embodiment 3, is also used for electric connection between the cold junction metal electrode 63p and the transistor 80. That is, the source 80s of the transistor 80 is electrically connected to the cold junction metal electrode 63p by the metal via 333. The transistor 80 that switches whether or not an infrared light detection signal is output from the infrared sensor 301 can be thus disposed below the cold junction metal electrode 63p. That is, in plan view, the transistor 80 and the cold junction metal electrode 63p overlap each other. This can reduce an area of the infrared sensor 301 in plan view, thereby achieving a reduction in size of the infrared sensor 301. Furthermore, it is possible to provide a small-sized infrared sensor array by using the infrared sensor 301 in an infrared sensor array.

Note that the high-concentration impurity region 313 may be provided in the semiconductor substrates 10 of the infrared sensors according to Embodiments 1 to 3. Furthermore, in the infrared sensor 201 according to Embodiment 3, the source 80s may be electrically connected to the cold junction metal electrode 63p by the metal via 333 without providing the metal wires 71 and 83 and the metal via 81.

### (Other Embodiments)

Although an infrared sensor according to the present disclosure has been described above on the basis of the embodiments, the present disclosure is not limited to these embodiments. Various modifications of the embodiments which a person skilled in the art can think of and other aspects constructed by combining some constituent elements in the embodiments are also encompassed within the scope of the present disclosure without departing from the spirit of the present disclosure.

For example, although the end surfaces 32 of the metal vias 31 are in contact with the semiconductor substrate 10 or 310 or the gate electrode 212 in the above embodiments, this is not restrictive. A thin film or the like may be disposed between the metal vias 31 and the semiconductor substrate 10 or 310 or the gate electrode 212.

Furthermore, for example, although the thermoelectric converter 60 is a thermopile thermoelectric conversion element in the above embodiments, this is not restrictive. The thermoelectric converter 60 may be a thermoelectric conversion element having a thermoelectric conversion structure other than a thermopile structure.

### Industrial Applicability

An infrared sensor according to the present disclosure can be used for various purposes including conventional use as an infrared sensor such as an infrared light imaging device. The infrared sensor according to the present disclosure can be applied to a drive monitor that can detect a person at night, simple thermography for efficiently performing group body temperature measurement, and the like since an uncooled but high-precision infrared sensor can be accomplished.

### Reference Signs List

1,1X,101,201,301 infrared sensor
2 package
3 thermistor chip
4 bonding wire
5 lid
6 infrared sensor package
10,310 semiconductor substrate
11 upper surface
20 insulating layer
21,22,41 insulating film
23 protective film
25 via hole
30,30A,30B,230,330 infrared light reflection structure
30X metal reflection film
31,35,81,81b,82,82b,231,232,333 metal via
31a,31b connection portion
32 end surface
40 light receiver
42 semiconductor
50 midair supporter
51 gap
53 recessed space
55 sacrificial layer
60 thermoelectric converter
61,62 hot junction metal electrode
63n,63p,64n,64p cold junction metal electrode
65n,66n N-type semiconductor
65p,66p P-type semiconductor
67,71,83,84 metal wire
80 transistor
80d drain
80g gate
80s source
80w well
91 substrate
92 constant-temperature bath
93 blackbody furnace
94 lens
95 housing
96 amplifier IC
112,212 gate electrode
313 high-concentration impurity region
Lin infrared incident light
Lre reflected light

## Claims

1. An infrared sensor comprising:
a substrate;
an insulating layer located on an upper surface of the substrate;
a first infrared light reflection structure provided in the insulating layer;
a light receiver located above the first infrared light reflection structure;
a midair supporter that supports the light receiver in midair so that a gap is formed between the first infrared light reflection structure and the light receiver; and
a thermoelectric converter that generates an infrared light detection signal on a basis of heat generated in the light receiver, wherein
the first infrared light reflection structure includes first metal vias extending in the insulating layer in a thickness direction of the insulating layer.

2. The infrared sensor according to claim 1, further comprising a second infrared light reflection structure disposed so as to surround the light receiver and the gap in plan view, wherein
the second infrared light reflection structure includes second metal vias extending in the insulating layer in the thickness direction of the insulating layer.

3. The infrared sensor according to claim 2, wherein
the thermoelectric converter is a thermopile thermoelectric conversion element including a hot junction metal electrode and a cold junction metal electrode, and
one of the second metal vias is in contact with the cold junction metal electrode.

4. The infrared sensor according to claim 3, further comprising a transistor that switches whether or not the infrared light detection signal generated by the thermoelectric converter is output from the cold junction metal electrode, wherein
the transistor is provided on the substrate, and
an input terminal of the transistor is electrically connected to the cold junction metal electrode by the one of the second metal vias.

5. The infrared sensor according to any one of claims 1 to 4, wherein
parts of outer peripheries of the first metal vias in plan view are connected to each other.

6. The infrared sensor according to any one of claims 1 to 4, wherein
end surfaces of the first metal vias on a substrate side are in contact with the substrate.

7. The infrared sensor according to any one of claims 1 to 4, further comprising a gate electrode located on the upper surface of the substrate, wherein
end surfaces of the first metal vias on a substrate side are in contact with the gate electrode.

8. The infrared sensor according to any one of claims 1 to 4, wherein
the substrate has a high-concentration impurity region doped with an impurity,
the high-concentration impurity region is located in an upper end portion of the substrate and located below the first infrared light reflection structure, and
an impurity concentration of the high-concentration impurity region is higher than an impurity concentration of a portion of the substrate that is located below the high-concentration impurity region.

9. The infrared sensor according to any one of claims 1 to 4, wherein
the midair supporter has a phononic crystal structure.
